# EUROPÄISCHE PATENTSCHRIFT

(11) **EP 1 335 212 B1**
(45) Veröffentlichungstag und Bekanntmachung des Hinweises auf die Patenterteilung: **09.04.2008**
(21) Anmeldenummer: 03002283.4
(22) Anmeldetag: 03.02.2003
(51) Int. Cl.: G01R 33/34

(54) **HF-Empfangsspulenanordnung für einen normalleitenden NMR-Resonator mit makroskopisch homogener Verteilung des leitenden Materials**
HF reception coil assembly for a normally conducting NMR resonator with macroscopically homogeneous distribution of the conducting material
Dispositif de bobines de réception HF pour résonateur normalement conducteur, avec une distribution de matériau conducteur macroscopiquement homogène

(30) Priorität: 12.02.2002 DE 10205625
(43) Veröffentlichungstag der Anmeldung: 13.08.2003
(73) Patentinhaber: Bruker BioSpin AG, 8117 Fällanden (CH)
(72) Erfinder: Marek, Daniel, 5103 Möriken (CH)
(74) Vertreter: Kohler Schmid Möbus

(56) Entgegenhaltungen:
- WO-A-96/39636
- DE-A- 3 414 559
- MINER V.W., CONOVER W.W.: "The Shimming of High Resolution NMR Magnets, Part V" INTERNET ARTICLE, [Online] 18. Dezember 2001 (2001-12-18), XP002304122 Gefunden im Internet: URL:http://web.archive.org/web/20011218022 629/http://www.acornnmr.com/Sam/sample.htm > [gefunden am 2004-11-05]

## Beschreibung

Die Erfindung betrifft eine HF(=Hochfrequenz)-Empfangsspulenanordnung für einen NMR(= Kernspinresonanz)-Resonator mit mindestens einem HF-Resonator zum Aussenden und/oder Empfangen von HF-Signalen auf einer oder mehreren gewünschten Resonanzfrequenzen in eine und/oder aus einer Messprobe in einem um einen Koordinatenursprung (x,y,z = 0) angeordneten Untersuchungsvolumen einer NMR-Apparatur mit einer Einrichtung zur Erzeugung eines homogenen Magnetfelds B₀ in Richtung einer z-Achse, wobei zwischen z = -|z₁| und z = +|z₂| normalleitende, induktiv und zum Teil auch kapazitiv wirkende Leiterstrukturen des HF-Resonators im wesentlichen auf einer in z-Richtung translations-invarianten (= z-invarianten) Fläche im radialen (x,y) Abstand senkrecht zur z-Achse angeordnet sind.

Eine solche Anordnung ist aus der DE 34 14 559 [2] bekannt.

Die vorliegende Erfindung betrifft das Gebiet der hochauflösenden Kernspinresonanz (NMR), insbesondere die Gestaltung von normalleitenden Resonatoren für den Empfang des NMR-Signals aus der NMR-Messprobe.

Eines der wesentlichen Probleme bei normalleitenden Resonatoren ist die magnetische Suszeptibilität, d.h. die dia- oder paramagnetischen Eigenschaften des Leiters, weil diese die Homogenität des statischen Magnetfeldes im Messvolumen und damit die Auflösung des NMR-Spektrums stark verschlechtern können. Um das zu verhindern, werden die Leiter im Allgemeinen aus mehreren Materialkomponenten mit unterschiedlichen dia- und paramagnetischen Eigenschaften aufgebaut, und der prozentuale Massenanteil der einzelnen Materialkomponenten so gewählt, dass die Gesamtsuszeptibilität des Leiters möglichst genau Null beträgt.

Trotz dieser Maßnahme bleibt im Allgemeinen immer eine Restsuszeptibilität übrig, die durch die vorhandenen Toleranzen beim Nullabgleich der Gesamtsuszeptibilität entsteht. Als Beispiel soll ein Kupferleiter herangezogen werden. Dieser ist sehr stark diamagnetisch, so dass sein Suszeptibilitätswert durch hinzufügen von paramagnetischen Materialanteilen auf ca 1% des Kupferwertes abgeglichen werden muss. Ein solch präziser Abgleich ist jedoch im Produktionsprozess schwer einzuhalten und führt im Allgemeinen zu einer erhöhten Ausschussrate. Es ist deshalb wünschenswert, Verfahren zu finden, die auch bei erhöhten Abgleichfehlern zu befriedigenden Resultaten führen.

Aufgabe der vorliegenden Erfindung ist es, eine neue Art von normalleitenden NMR-Resonatoren vorzustellen, bei denen zusätzliche Leiterstrukturen hinzugefügt werden, die möglichst gut vom eigentlichen HF-Resonator entkoppelt sind, und die den Störeinfluss, hervorgerufen durch die Suszeptibilität des Leiters, so gut wie möglich kompensieren sollen.

Erfindungsgemäß wird diese Aufgabe bei einer HF-Empfangsspulenanordnung für einen NMR-Resonator mit den eingangs beschriebenen Merkmalen dadurch gelöst, dass auf der in z-Richtung translations-invarianten (= z-invarianten) Fläche zusätzlich eine Kompensations-Anordnung vorgesehen ist, die sich mindestens bis zu Werten z < -|z₁| - 0.5 |r| und z > +|z₂| + 0.5 |r| erstreckt, wobei |r| der kleinste vorkommende Abstand zwischen dem Untersuchungsvolumen und der Kompensations-Anordnung bedeutet, dass die Kompensations-Anordnung weitere Leiterstrukturen umfasst, welche voneinander beabstandet und HF-mäßig vom HF-Resonator weitgehend entkoppelt sind, dass die Leiterstrukturen der Kompensations-Anordnung und des HF-Resonators ihrerseits aus einzelnen, normalleitende Leiterstrukturen enthaltenden Flächenabschnitten (="Z-Strukturen") zusammengesetzt sind, die in der z-invarianten Fläche liegen, jeweils über die ganze Länge in z-Richtung der Leiterstrukturen der Kompensations-Anordnung und des HF-Resonators verlaufen, und deren Leiterstrukturen so angeordnet sind, dass bei einer geeigneten mathematischen Zerlegung der Fläche der Z-Strukturen in eine Vielzahl kleiner, gleich großer Flächenelemente, in allen Flächenelementen, die sich nur in ihrer z-Position unterscheiden, eine weitgehend gleiche Masse von normalleitendem Material enthalten ist.

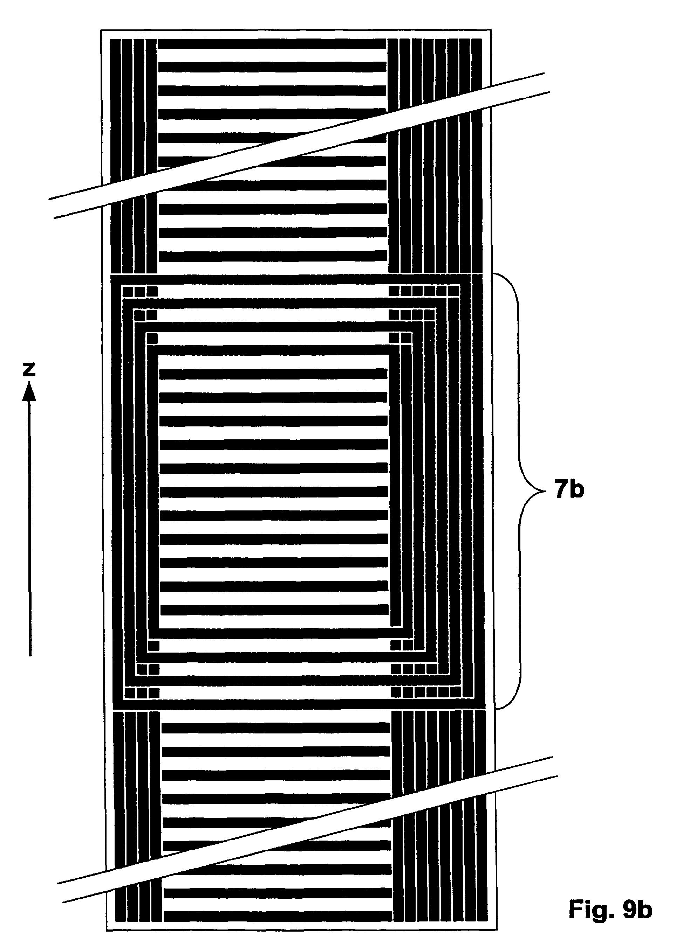

Beim erfindungsgemäßen Resonator werden die einzelnen normalleitenden Leiterteile, die den Hochfrequenz(HF)-Strom tragen und somit den HF-Resonator bilden, durch zusätzliche normalleitende Leiterteile ergänzt, die sowohl innerhalb des HF-Resonators wie auch in z-Richtung verlängernd, quasi-kontinuierlich angeordnet und HF-mäßig so gut wie möglich vom HF-Resonator entkoppelt sind, damit sie keinen HF-Strom tragen. Fig. 9b zeigt eine nach diesem Prinzip aufgebaute Anordnung, wobei der HF-Resonator schraffiert und die zusätzlichen Leiterteile, die lediglich der Homogenisierung des B₀-Feldes im aktiven Messbereich dienen, schwarz dargestellt sind. Man erkennt deutlich, dass innerhalb jeder einzelnen der drei senkrechten Strukturflächen, die parallel zur z-Achse orientiert sind, das darin vorhandene Leitermaterial sehr homogen verteilt ist, was auch eine gleichmäßige Verteilung der durch die Suszeptibilität des Leitermaterials herrührende Dipolmomente zur Folge hat. Es entsteht dadurch ein praktisch verschwindendes Störfeld im Messvolumen, so dass das NMR-Spektrum nicht mehr signifikant beeinflusst wird.

Im weiteren Verlauf der Beschreibung werden die Begriffe NMR-Resonator, HF-Empfangsspulenanordnung und HF-Resonator mehrfach vorkommen. Sie haben alle eine ähnliche Bedeutung und sollen deshalb an dieser Stelle genauer definiert werden, damit ihr Unterschied klar erkennbar ist:
Ein **NMR-Resonator** stellt die komplette Resonator-Anordnung dar. Er setzt sich zusammen aus einer oder mehreren, vorzugsweise 2 oder 4 **HF-Empfangsspulenanordnungen**, die um das Messvolumen herum angeordnet sind und HF-mäßig miteinander koppeln können. Die HF-Empfangsspulenanordnung ihrerseits besteht aus dem **HF-Resonator** und der Kompensations-Anordnung, wobei der HF-Resonator im Wesentlichen den HF-Strom tragenden Teil der HF-Empfangsspulenanordnung darstellt.

Um die erfindungsgemäßen HF-Empfangsspulenanordnungen zu konstruieren und zu analysieren ist es zweckmäßig, ihre gesamte Leiterstruktur gedanklich in streifenförmige Flächen parallel zur z-Achse aufzuteilen, wobei diese Flächen jeweils aus einer einzigen Reihe von identischen kleinen Flächenelementen aufgebaut sind. Damit nun eine wirkungsvolle Kompensation des Suszeptibilitätseffektes stattfinden kann, müssen innerhalb den Flächenelementen eines einzelnen Streifens jeweils möglichst gleich viele magnetische Dipolmomente, d.h. gleich viel Leitermaterial vorhanden sein.

Je kleiner die Elemente der Leiterstruktur sind, desto feiner kann die Gesamtfläche der HF-Empfangsspulenanordnung in Streifen mit identischen kleinen Flächenelementen eingeteilt werden. Es ist nämlich zu beachten, dass die kleinste Dimension der Flächenelemente nicht kleiner als die kleinste Dimension der Strukturelemente sein darf, da sonst die Möglichkeit besteht, dass einzelne Flächenelemente überhaupt kein Leitermaterial enthalten und deshalb die Bedingung einer identischen Anzahl von Dipolmomenten pro Flächenelement nicht eingehalten werden kann. Eine möglichst feine Flächeneinteilung ist jedoch erforderlich, wenn die Welligkeit des Störfeldes im aktiven Messbereich, die durch die magnetischen Dipolmomente des Leitermaterials in den einzelnen Flächenelementen hervorgerufen wird, möglichst klein sein soll. Eine vernünftig feine Einteilung erhält man, wenn die Gesamtzahl der Flächenelemente größer als 50, vorzugsweise größer als 200 ist.

Im Wesentlichen kommt es jedoch bei dieser Einteilung nur auf die Anzahl der identischen Flächenelemente an, die sich nur durch ihre z-Position unterscheiden, d.h. auf Streifen liegen, die parallel zur z-Achse orientiert sind. Diese Anzahl sollte größer als 20, vorteilhafterweise größer als 50 sein.

Besonders bevorzugt ist auch eine Ausführungsform der erfindungsgemäßen HF-Empfangsspulenanordnung, bei der die Leiterstrukturen der Kompensations-Anordnung den HF-Resonator beidseits jeweils um mindestens die halbe, vorzugsweise etwa die zweifache Ausdehnung des HF-Resonators in z-Richtung überragen. Dadurch rücken die in z-Richtung vorhandenen Randbereiche der Kompensations-Anordnung, die für die Störeinflüsse im aktiven Messbereich hauptsächlich verantwortlich sind, möglichst weit räumlich vom aktiven Messbereich weg und können diesen nicht mehr signifikant beeinflussen.

Eine geometrisch und herstellungstechnisch besonders einfache Ausgestaltung der Erfindung ergibt sich dadurch, dass die induktiv und zum Teil auch kapazitiv wirkenden Leiterstrukturen des oder der HF-Resonatoren und die Leiterstrukturen der Kompensations-Anordnung(en) auf ebenen Substratelementen aufgebracht sind, die untereinander und zur z-Achse parallel angeordnet sind.

Einen besonders guten Füllfaktor erhält man, wenn die induktiv und zum Teil auch kapazitiv wirkenden Leiterstrukturen des oder der HF-Resonatoren sowie die Leiterstrukturen der Kompensations-Anordnung(en) auf zylinderförmigen Substratelementen aufgebracht sind, die untereinander konzentrisch und zur z-Achse parallel angeordnet sind.

Ganz besonders einfach in der Herstellung ist eine Ausführungsform der erfindungsgemäßen HF-Empfangsspulenanordnung, bei der die induktiv und zum Teil auch kapazitiv wirkenden Leiterstrukturen des HF-Resonators sowie die Leiterstrukturen der zugehörigen Kompensations-Anordnung in derselben Ebene oder auf derselben Zylinderfläche angeordnet sind.

Eine alternative Ausführungsform zeichnet sich dadurch aus, dass die Leiterstrukturen des HF-Resonators und der zugehörigen Kompensationsanordnung in zwei oder mehreren ebenen oder zylinderförmigen Teilflächen liegen, die parallel resp. konzentrisch zueinander angeordnet sind, wobei in der ersten Teilfläche die induktiv und zum Teil auch kapazitiv wirkenden Leiterstrukturen des HF-Resonators sowie Teile der zugehörigen Leiterstrukturen der Kompensations-Anordnung, in den weiteren Teilflächen die verbleibenden Teile der Leiterstrukturen der Kompensations-Anordnung angeordnet sind. Durch diese etwas kompliziertere Anordnung ergibt sich ein weiterer physikalischer Freiheitsgrad, mit dem eine sehr genaue Kompensation der durch die Suszeptibilität der Leiterstrukturen hervorgerufenen Störeinflüsse möglich ist.

Bei einer Weiterbildung dieser Ausführungsform betragen die Abstände zwischen den Teilflächen, gemessen in einer Richtung senkrecht zu den Teilflächen, maximal 600µm, vorzugsweise maximal zwischen 50 und 200µm. Diese Abstände müssen möglichst klein gehalten werden, um Fehler in der Kompensation des Suszeptibilitätseinflusses zu minimieren.

Besonders bevorzugt ist eine einfache Ausführungsform der Erfindung, bei der die Leiterstrukturen der Kompensations-Anordnung und des HF-Resonators auf derselben Teilfläche der z-invarianten Fläche angeordnet sind. Ausgehend von dieser Ausführungsform lassen sich eine Vielzahl von weiteren Ausführungsformen ableiten, die durch ihren einfachen Aufbau charakterisiert sind.

Bei einer weiteren besonders bevorzugten, sehr einfachen Ausführungsform der Erfindung ist zumindest ein Teil der Abschnitte der Leiterstrukturen streifenförmig achsparallel oder achssenkrecht zur z-Richtung angeordnet. Diese Ausführungsform besitzt eine einfache Geometrie und dient als Ausgangspunkt zur Herstellung von verschiedenen Z-Strukturen.

Mehr Spielraum für Variationen ermöglicht eine Ausführungsform, bei der die Leiterstrukturen auf den z-invarianten Flächen aus verschiedenen geometrischen Formen zusammengesetzt sind, z.B. aus Streifen verschiedener Orientierung und Breite sowie aus Rechtecken, Kreisen, Trapezen, etc. Dadurch ergibt sich eine erhöhte Flexibilität im Entwurf der Gesamtgeometrie, so dass die Optimierung der Fehlerkompensation noch besser erreicht werden kann.

Eine sehr zweckmäßige Z-Struktur, die einzeln oder mehrfach in einer erfindungsgemäßen HF-Empfangsspulenanordnung verwendet werden kann, besteht aus identischen, schmalen Leitern, welche eng aufeinander folgend und periodisch kontinuierlich in z-Richtung angeordnet sind, wobei der Abstand benachbarter Leiter klein gegenüber dem kleinsten vorkommenden Abstand |r| zum Untersuchungsvolumen ist.

Eine weitere sehr zweckmäßige Z-Struktur, die einzeln oder mehrfach in einer erfindungsgemäßen HF-Empfangsspulenanordnung verwendet werden kann, besteht aus einzelnen Leitern, die parallel zur z-Achse ausgerichtet sind und gleiche oder unterschiedliche Abstände zueinander haben.

Besonders bevorzugt ist eine Ausführungsform der erfindungsgemäßen

HF-Empfangsspulenanordnung, bei der die Leiterstrukturen, die nicht zum HF-Resonator gehören, eine Anzahl von schmalen Unterbrüchen enthalten, die über Teile oder die ganze Länge der einzelnen Leiterabschnitte verteilt sind. Damit wird eine erheblich bessere HF-Entkopplung zwischen dem HF-Resonator und der Kompensations-Anordnung erreicht, weil die in der Regel entstehenden Ströme in den Leiterstrukturen durch die Unterbrüche besonders gering gehalten bzw. unterdrückt werden.

Bei einer weiteren Ausführungsform der Erfindung wird die Erzeugung des HF-Resonators aus den gewünschten Bereichen der Z-Strukturen dadurch erreicht, dass innerhalb von kleinen Flächenelementen der Z-Strukturen der darin enthaltene Leiter oder Teile davon gedreht oder verschoben werden, und/oder dass schmale Abstände zwischen den Leitern galvanisch verbunden werden, und/oder dass schmale Unterbrüche in den Leitern angebracht werden, und/oder dass schräge

Z-Strukturen verwendet werden, und/oder dass die Z-Strukturen auf zwei oder mehreren Teilflächen verteilt werden.

Eine ganz konkrete, besonders bevorzugte Ausführungsform, welche einen recht einfachen geometrischen Aufbau aufweist, zeichnet sich dadurch aus, dass die HF-Empfangsspulenanordnung aus drei Z-Strukturen aufgebaut ist, nämlich links und rechts je eine mit vertikalen und dazwischen eine mit horizontalen geraden Streifen.

Eine sehr genaue Kompensation mit vielen Variationsmöglichkeiten liefert eine weitere Ausführungsform der Erfindung, bei der die ganze HF-Empfangsspulenanordnung in zwei Ebenen angeordnet und aus drei Z-Strukturen zusammengesetzt ist, nämlich aus einer ersten und zweiten mit parallel zur z-Achse sowie einer dritten mit in z periodisch und quer zur z-Achse angeordneten Streifen, wobei die dritte Z-Struktur über den beiden ersten, die einen bestimmten Abstand zueinander haben, positioniert ist und diese genau überdeckt, und wobei die Zusammensetzung des HF-Resonators und der Kompensationsstruktur dadurch erfolgt, dass die drei Z-Strukturen teilweise zerlegt und auf zwei separaten Teilflächen, die zu einem oder zwei Substraten gehören, verteilt werden, wobei die erste Teilfläche den ganzen HF-Resonator mit dem Hauptanteil der Kompensations-Struktur, und die zweite Teilfläche den Restanteil der Kompensations-Struktur enthält, und dass die so entstandenen Strukturen auf den beiden Teilflächen derart aufeinander positioniert werden, dass die Summe ihrer Strukturen wieder gleich der Summe der ursprünglichen drei Z-Strukturen ist, und dass dadurch ein funktionsfähiger NMR-Resonator entsteht.

In den Rahmen der vorliegenden Erfindung fällt auch ein NMR-Resonator, der eine oder mehrere erfindungsgemäße HF-Empfangsspulenanordnungen umfasst.

Zur Optimierung des Füllfaktors werden NMR-Resonatoren meistens aus mehreren HF-Empfangsspulenanordnungen zusammengesetzt. Bei einer vorteilhaften Ausführungsform der Erfindung enthält daher der NMR-Resonator mehrere gekoppelte HF-Empfangsspulenanordnungen, vorzugsweise 2 oder 4, auf unterschiedlichen Teilflächen der z-invarianten Fläche.

Weitere Vorteile ergeben sich aus den Zeichnungen und der Beschreibung. Ebenso können die vorstehend genannten und die noch weiter aufgeführten Merkmale erfindungsgemäß einzeln für sich und zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in Zeichnungen dargestellt und wird anhand von Ausführungsbeispielen näher erläutert.

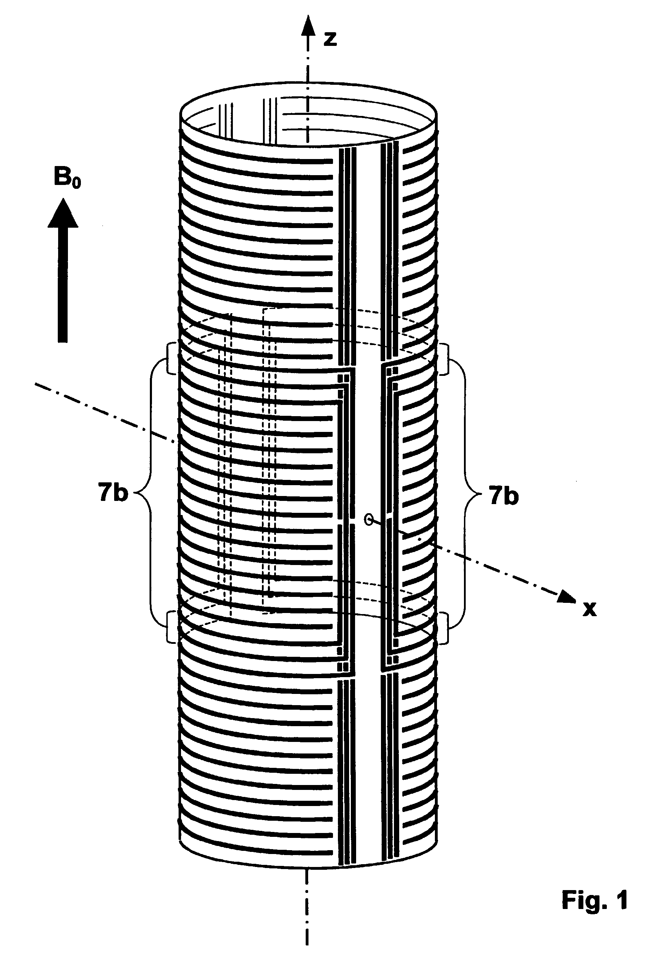

- Fig. 1: Zeigt eine Ausführungsform des erfindungsgemäßen NMR-Resonators, bei der die Leiterstrukturen auf einer Zylinderoberfläche liegen. Nicht eingezeichnet sind die normalerweise vorhandenen elektrischen Unterbrüche in den Kompensationsstrukturen, welche eine bessere HF-Entkopplung zwischen diesen Strukturen und den Strukturen des HF-Resonators erlauben.

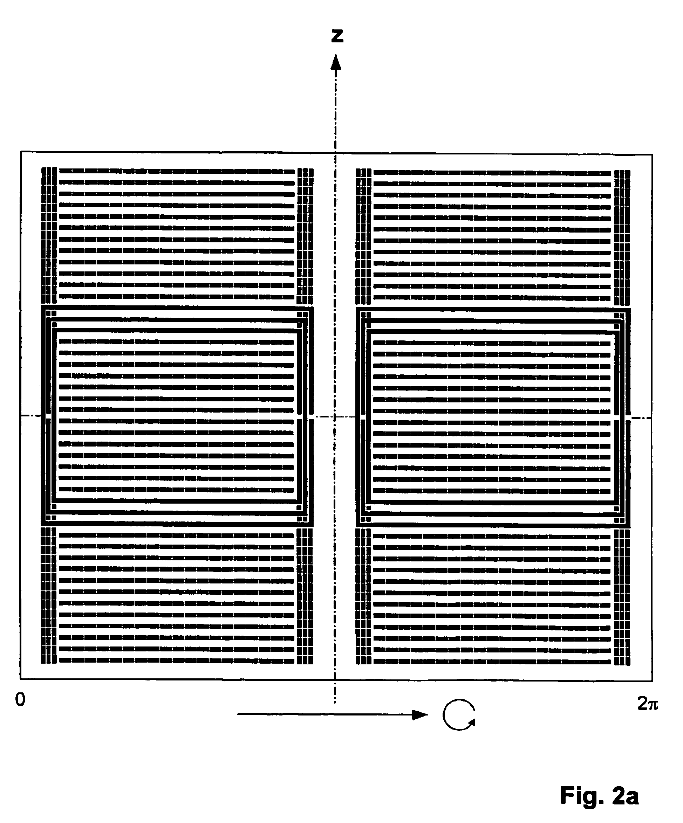

- Fig. 2a: Zeigt den NMR-Resonator von Fig. 1, der auf eine Ebene abgewickelt wurde. Die unter Fig. 1 erwähnten elektrischen Unterbrüche sind hier eingezeichnet und deutlich erkennbar.

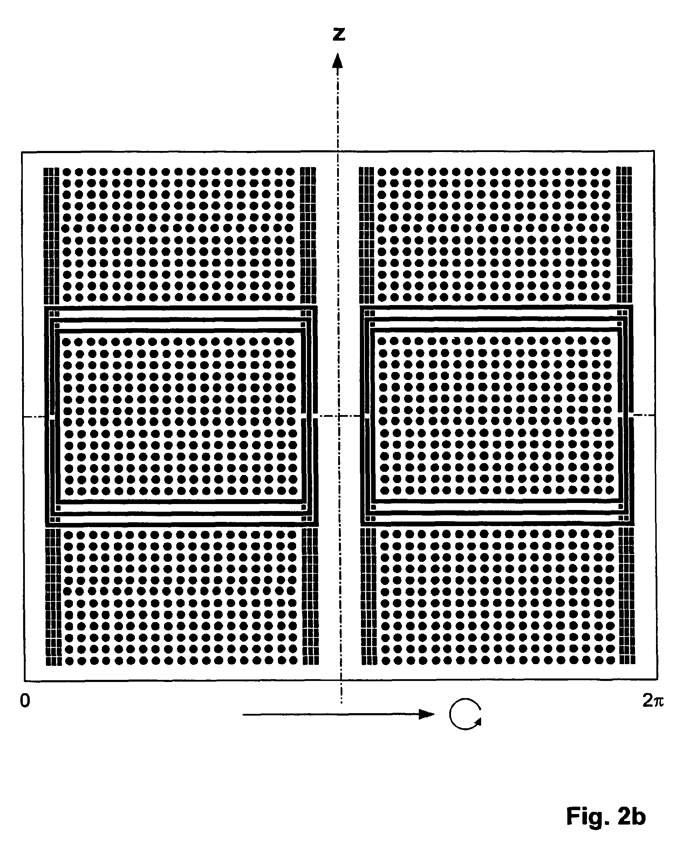

- Fig. 2b: Zeigt eine weitere Möglichkeit, wie die Kompensations-Struktur gestaltet werden kann, nämlich mit punktförmigen Leitern anstatt geraden Leitern. Der Massenanteil pro Flächenelement der punktförmigen sowie der horizontalen Leitern muss entlang den Flächenelementen, die sich nur in ihrer z-Position unterscheiden, gleich groß sein, damit eine optimale Kompensation der Suszeptibilität der Leiter erreicht wird.

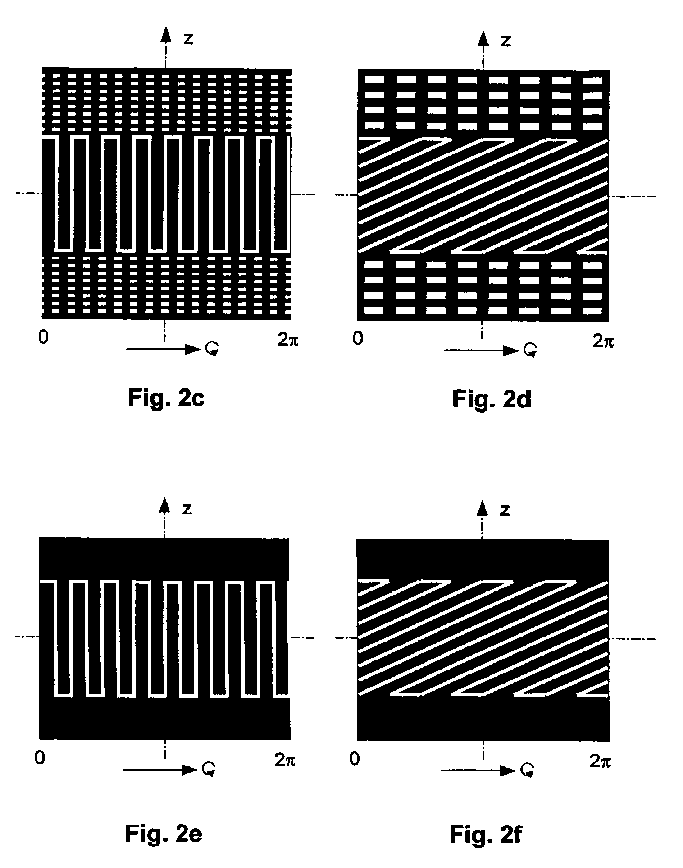

- Fig. 2c: Zeigt einen NMR-Resonator, bei dem der Resonator aus einzelnen Fingern besteht, die ineinander greifen, kapazitiv miteinander koppeln und gesamthaft einen sogenannten Birdcage-Resonator darstellen. Die einzelnen Finger sind parallel zur z-Achse, d.h. parallel zum B₀-Feld angeordnet. Die Kompensationsstrukturen befinden sich oberhalb und unterhalb der Fingeranordnungen. Sie entstehen durch Anbringen einer Vielzahl von rechteckigen Löchern und erlauben, dass Ströme sowohl parallel wie auch senkrecht zur z-Achse fließen können.
- Fig. 2d: Wie Fig. 2c jedoch mit schrägen Fingern, die spiralförmig über einen Winkelbereich von 2π um die Zylinderfläche gewickelt sind. Diese Anordnung hat den Vorteil, dass bei mehreren, konzentrisch zueinander positionierten Anordnungen, praktisch keine HF-Kopplung zwischen den einzelnen Anordnungen vorhanden ist.
- Fig. 2e: Wie Fig. 2c jedoch ohne Kompensationsstruktur. Diese Anordnung entspricht dem Stand der Technik.
- Fig. 2f: Wie Fig. 2d jedoch ohne Kompensationsstruktur. Diese Anordnung entspricht dem Stand der Technik.

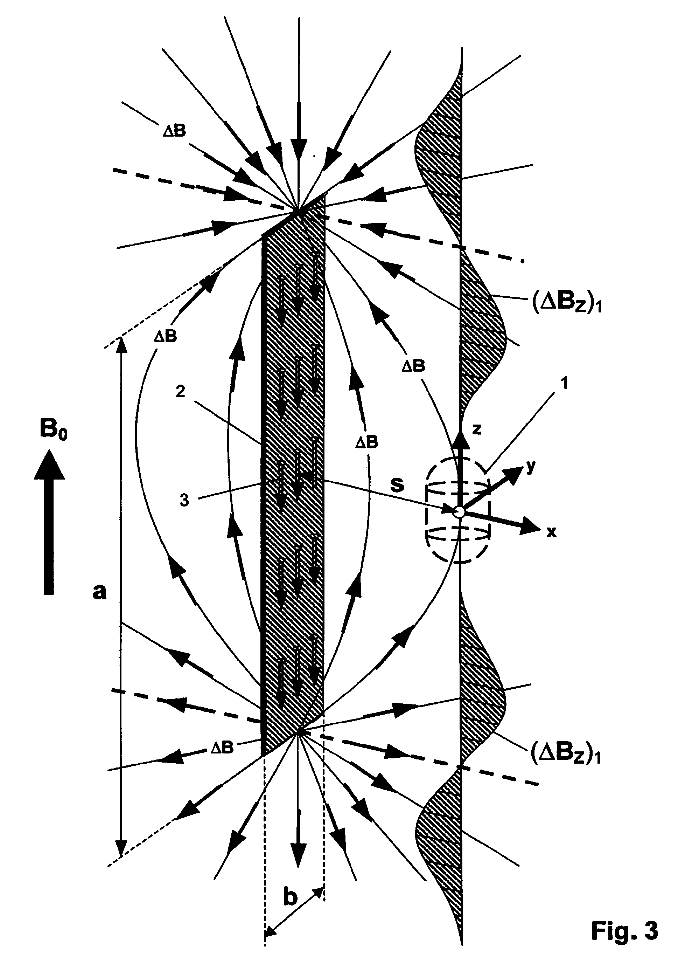

- Fig. 3: Feld ΔB, das von einem diamagnetischen Leiterstreifen erzeugt wird, dessen Längsachse parallel zu B₀ steht. Die z-Komponente (ΔB_{Z})₁ des Feldes ΔB ist im Bereich des aktiven Messvolumens 1 praktisch Null und tritt nur am oberen und unteren Rand des Streifens auf.

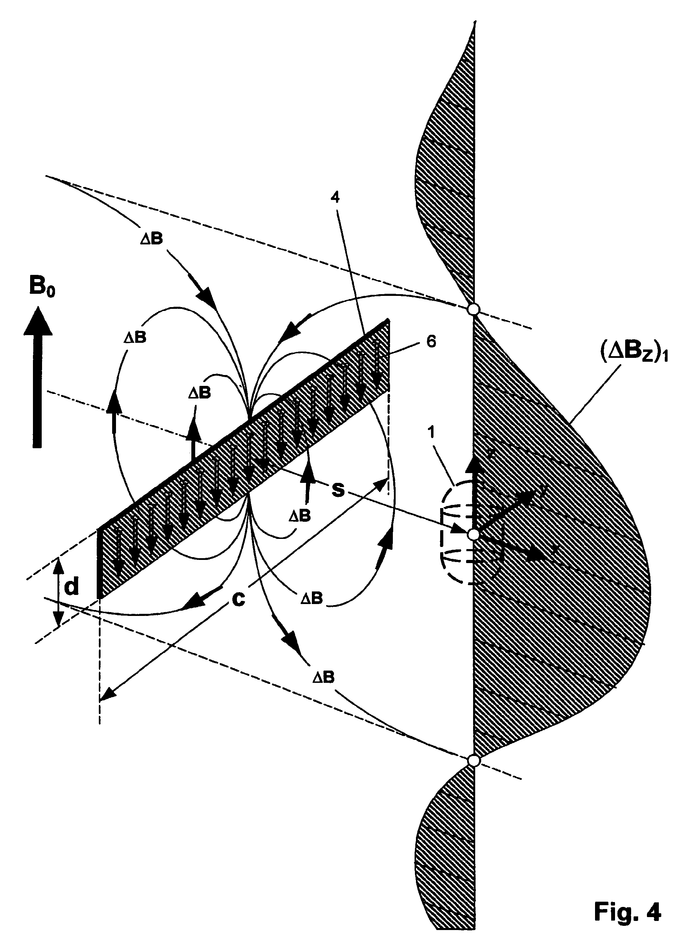

- Fig. 4: Feld ΔB, das von einem diamagnetischen Leiterstreifen erzeugt wird, dessen Längsachse senkrecht zu B₀ steht. Im Bereich des aktiven Messvolumens 1 sind die z-Komponenten (ΔB_{Z})₁ des Feldes ΔB stark inhomogen.

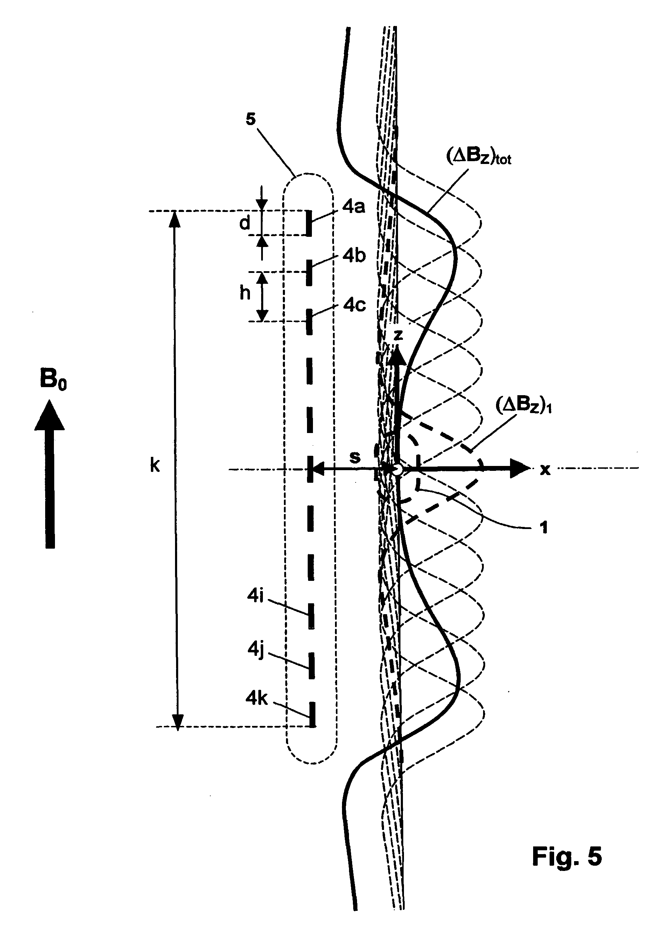

- Fig. 5: Anordnung aus mehreren Leiterstreifen 4a, 4b, 4c bis 4k, die auf einer Ebene parallel zu B₀ liegen und gleichmäßig übereinander angeordnet sind. Die B_{Z}-Komponente (ΔB_{Z})₁ der einzelnen Streifen überlagern sich und erzeugen das Feld (ΔB_{Z})ₜₒₜ. Dieses ist im Bereich des aktiven Messvolumens 1 praktisch Null und besitzt dort nur sehr kleine Bz-Komponenten, die mit Hilfe des Raumtemperatur-Shimsystems problemlos zu kompensieren sind. Stärkere B_{Z}-Komponenten treten nur im Bereich des oberen und unteren Endes des Streifens auf, d.h. in einem Bereich, der praktisch keinen Einfluss auf das aktive Messvolumen besitzt.

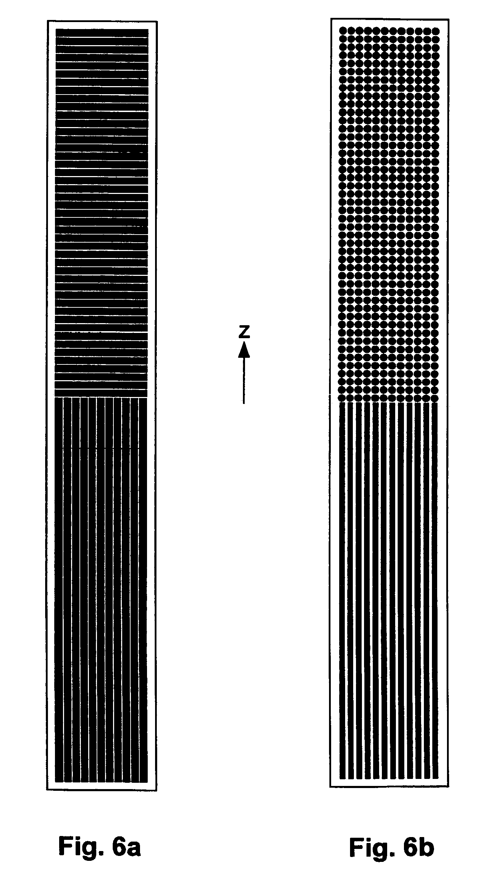

- Fig. 6a: Leiterstruktur, die aus parallel und senkrecht zum B₀-Feld orientierten Streifen zusammengesetzt ist. Die Streifen sind so verteilt, dass überall gleich viel Leitermaterial pro Flächenelement vorhanden ist. Dadurch können Störfelder nur am oberen und unteren Rand der gesamten Leiterstruktur entstehen.
- Fig. 6b: Leiterstruktur, die aus parallel zum B₀-Feld orientierten Streifen sowie aus kreisförmigen Leiterpunkten zusammengesetzt ist. Die Streifen und Leiterpunkte sind so verteilt, dass überall gleich viel Leitermaterial pro Flächenelement vorhanden ist. Dadurch können Störfelder nur am oberen und unteren Rand der gesamten Leiterstruktur entstehen.

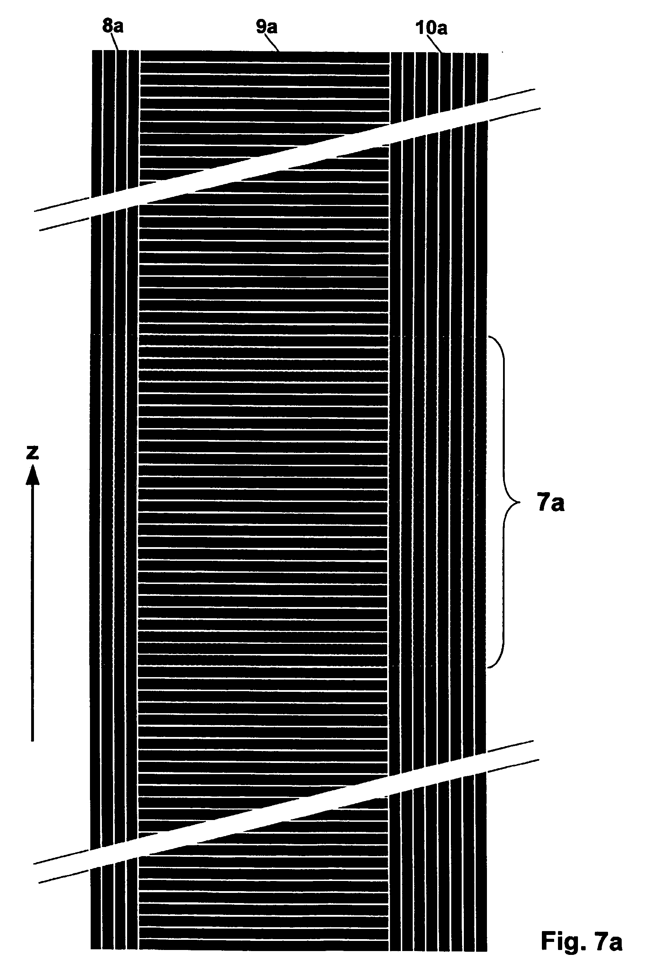

- Fig. 7a: Leiterstruktur, die eine konstante Breite besitzt, in z-Richtung stark ausgedehnt ist und aus drei Teilstrukturen aufgebaut ist, nämlich zwei mit Streifen parallel und eine mittlere mit Steifen senkrecht zum B₀-Feld. Aus dem schraffierten Bereich 7a lässt sich der HF-Resonator aufbauen. Die übrigen Bereiche sind erforderlich, um den Suszeptibilitätseinfluss des HF-Resonators zu kompensieren.

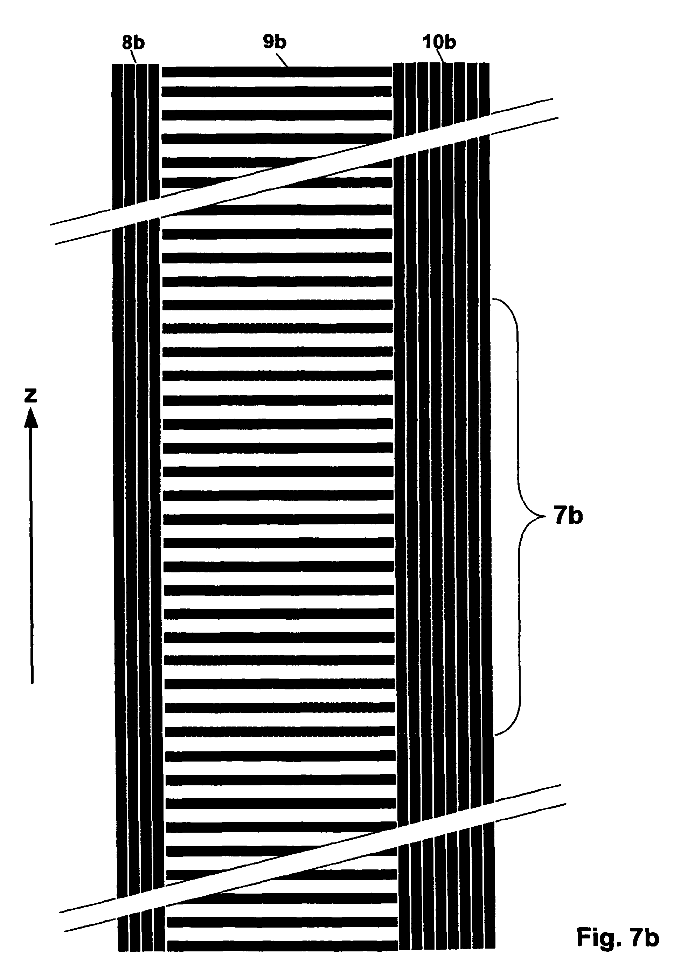

- Fig. 7b: Leiterstruktur wie in Fig. 7a, jedoch mit dem Unterschied, dass die Streifen der mittleren Teilstruktur einen größeren Abstand zueinander haben. Dadurch wird die HF-Durchlässigkeit dieser Teilstruktur verbessert.

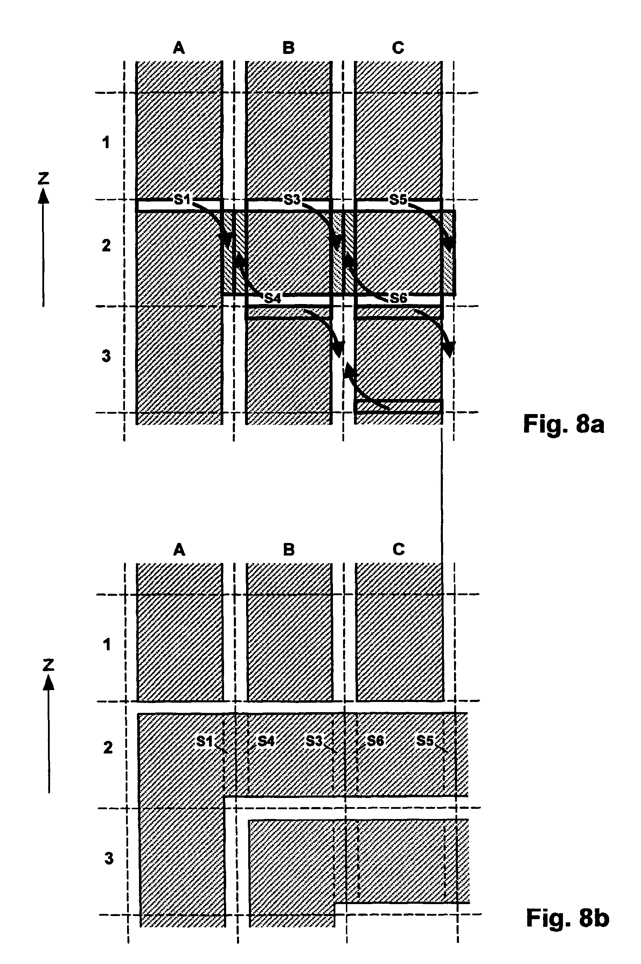

- Fig. 8a: Ausschnitt des oberen Endes des schraffierten Teils der Teilstruktur 8a in Fig. 7a. Die Darstellung zeigt, wie z.B. Flächenanteile s1, s3, s4, s5 und s6 der Leiterstruktur innerhalb den zugehörigen Flächenelementen A2, B2 resp.C2 verschoben und gedreht werden müssen, um eine Ecke des HF-Resonators zu konstruieren.
- Fig. 8b: Resultierende Leiterstruktur nach erfolgter Verschiebung und Drehung einiger Flächenanteile, wie dies in Fig. 8a dargestellt ist.

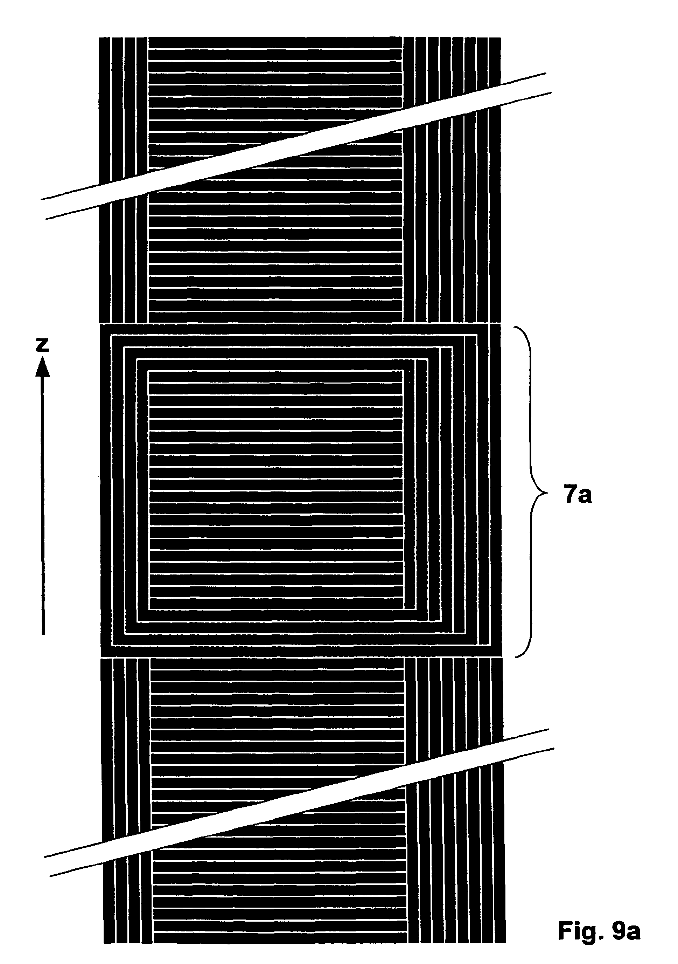

- Fig. 9a: Zeigt die **erste Ausführungsform** eines erfindungsgemäßen Resonators, der aus der schraffierten Struktur von Fig. 7a und unter Verwendung des Transformationsvorganges gemäß Fig. 8a erzeugt wurde. Der Bereich 7a, in dem der HF-Strom fließt, ist schraffiert markiert. Die gesamte Leiterstruktur erzeugt praktisch keine Störfelder im aktiven Messbereich!
- Fig. 9b: Zeigt die **zweite Ausführungsform** eines erfindungsgemäßen Resonators, der aus der schraffierten Struktur von Fig. 7b und unter Verwendung der Transformationsvorganges gemäß Fig. 8a erzeugt wurde. Der Bereich 7b, in dem der HF-Strom fließt, ist schraffiert markiert. Die gesamte Leiterstruktur er erzeugt praktisch keine Störfelder im aktiven Messbereich!

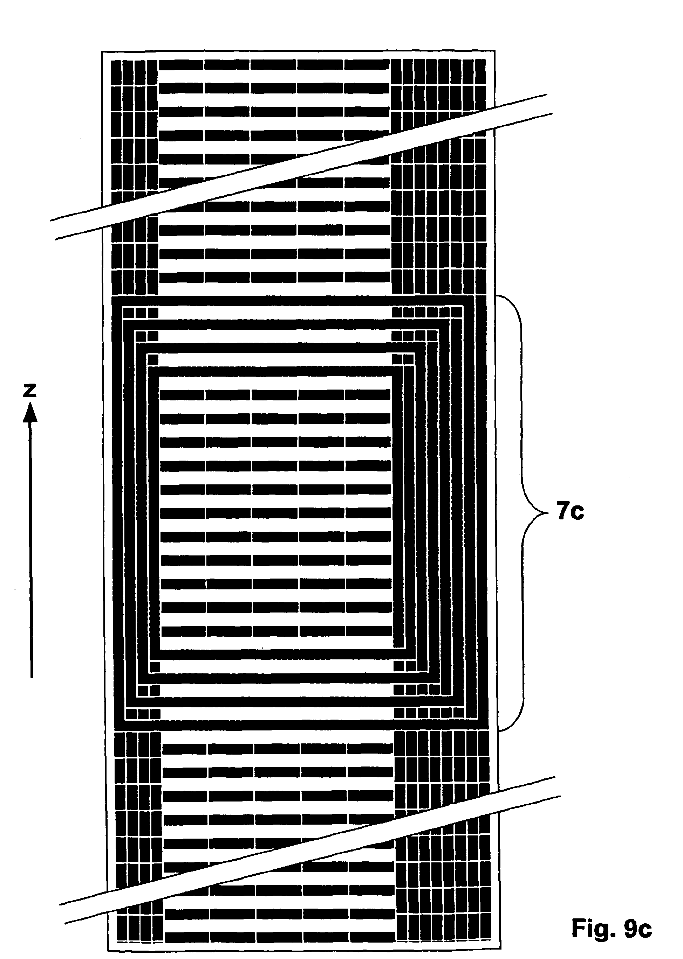

- Fig. 9c: Zeigt nochmals die **zweite Ausführungsform** des erfindungsgemäßen Resonators von Fig. 9b mit dem Unterschied jedoch, dass die Leiter der Kompensationsstruktur unterteilt sind. Dadurch lässt sich die HF-Kopplung zwischen HF-Resonator und Kompensationsstruktur stark verringern.

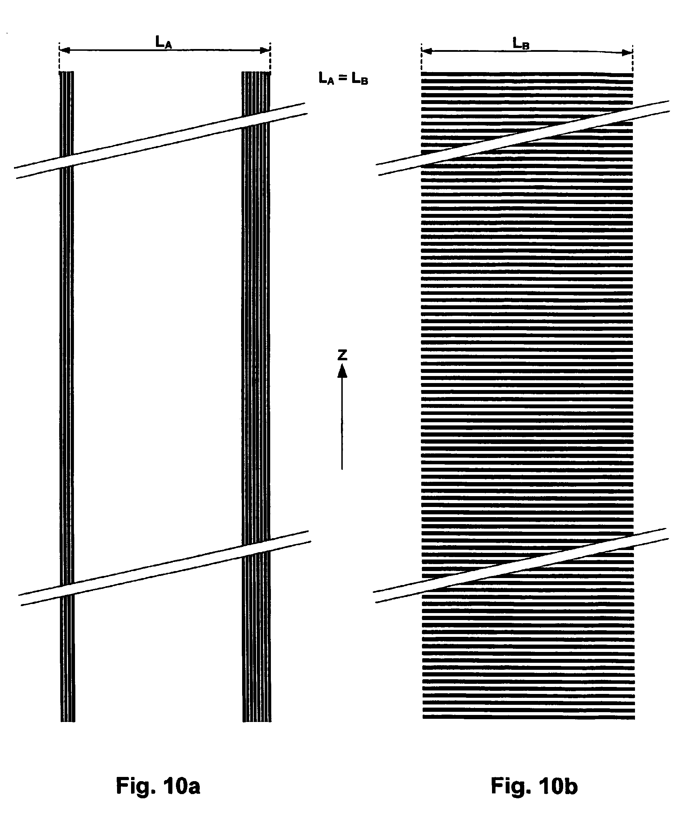

- Fig. 10a: Zeigt zwei Leiterstrukturen, deren Leiter parallel zur z-Achse orientiert sind, und aus denen ein Teil der **dritten Ausführungsform** eines erfindungsgemäßen Resonators hergestellt wird.
- Fig. 10b: Zeigt eine Leiterstruktur, deren Leiter senkrecht zur z-Achse orientiert sind, und aus denen ein Teil der **dritten Ausführungsform** eines erfindungsgemäßen Resonators hergestellt wird.

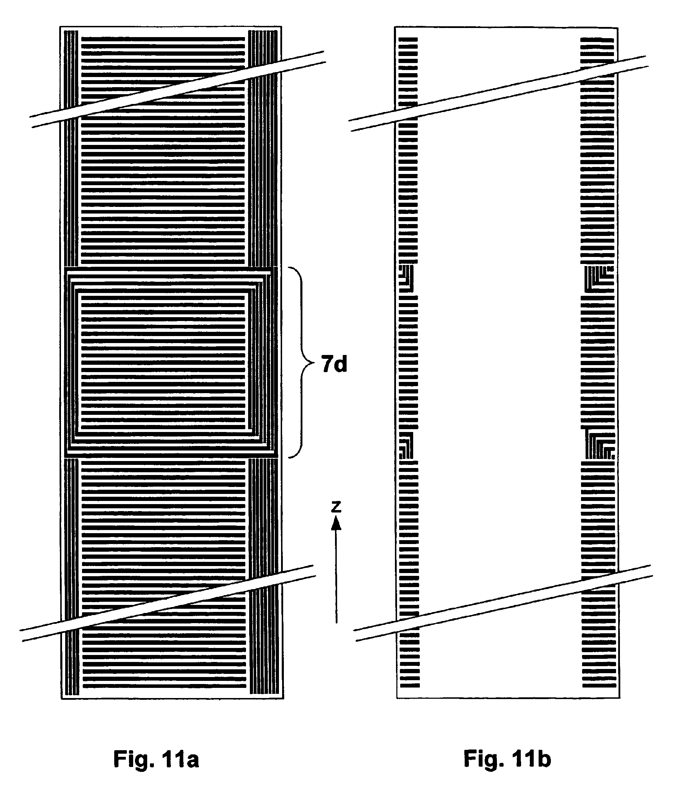

- Fig. 11a: Leiterstruktur auf der ersten der beiden Flächen der **dritten Ausführungsform** eines erfindungsgemäßen Resonators. Das Substrat enthält den HF-Resonator 7d und den Hauptanteil der Kompensations-Anordnung.
- Fig. 11b: Leiterstruktur auf der zweiten der beiden Flächen der **dritten Ausführungsform** eines erfindungsgemäßen Resonators. Mit dieser Leiterstruktur wird der Restanteil der Kompensations-Anordnung realisiert. Diese kann nicht auf der ersten Fläche angebracht werden, weil sonst verschiedene Leiter sich kreuzen oder überlappen würden.

Es folgen nun weitere Erklärungen zur Funktionsweise der erfindungsgemäßen Ausführungsformen.

Ein Streifen aus leitendem Material besitzt im Allgemeinen eine endliche magnetische Suszeptibilität, welche durch die magnetischen Dipole im Material hervorgerufen wird. Diese Dipole werden im statischen Magnetfeld B₀, in welchem sich das Material befindet, polarisiert und verzerren das umliegende Feld und damit auch die Güte des NMR-Spektrums. Das NMR-Spektrum wird nur von den Feldkomponenten beeinflusst, die innerhalb des aktiven Messvolumens parallel zum B₀-Feld orientiert sind. Die x- und y-Komponenten hingegen, die senkrecht zum B₀-Feld orientiert sind, dürfen vernachlässigt werden.

Diese Suszeptibilät ist auch dann vorhanden, wenn das Material aus annähernd gleichen Massenanteilen para- und diamagnetischen Anteilen zusammengesetzt ist, wobei in diesem Fall die resultierende Suszeptibilität zwar sehr klein sein kann, z.B. nur ein bis wenige Prozente der Suszeptibilität von Kupfer, aber trotzdem noch groß genug, um ein hoch aufgelöstes NMR-Spektrum negativ zu beeinflussen.

Zweck dieser Erfindung ist es deshalb, neue Methoden zu beschreiben, mit denen der Einfluss der noch vorhandenen Suszeptibilität weiter verringert werden kann, auch dann, wenn die Suszeptibilität des Materials mit Hilfe von para- und diamagnetischen Materialanteilen ungenau oder sogar gar nicht abgeglichen wurde. Diese neuen Methoden sollen nicht direkt die Suszeptibilität des Materials beeinflussen (diese bleiben unverändert erhalten), sondern sollen durch eine geeignete geometrische Gestaltung des NMR-Resonators den Einfluss der Suszeptibilität des Materials auf das NMR-Spektrum deutlich verringern.

Sofern der Leiterstreifen exakt parallel zum B₀-Feld orientiert ist, besitzt er in seinem Innern nur magnetische Dipole, welche parallel zur Längsachse des Streifens orientiert sind. Der gesamte Einfluss dieser Dipole kann durch eine **Vielzahl von positiven resp. negativen magnetischen Monopolen** (Fig. 3) dargestellt werden, **die sich ausschließlich an einem resp. am anderen Enden des Streifens befinden** und ein Störfeld ΔB erzeugen, das nur im Bereich dieser beiden Enden bemerkbar ist. Sofern die beiden Enden des Streifens weit voneinander entfernt sind, d.h. wenn der kleinste Abstand des aktiven Messvolumens zu den beiden Enden des Streifens groß gegenüber dem Abstand s zwischen dem Zentrum des aktiven Messvolumens und dem Streifen ist, dann sind im Bereich des aktiven Messvolumens praktisch keine Störkomponenten vorhanden (siehe (ΔB_{Z})₁).

Wenn der Streifen nicht ganz exakt parallel zum B₀-Feld ausgerichtet ist, treten neben den magnetischen Dipolen, die parallel zur Oberfläche des Streifens orientiert sind, auch solche, die senkrecht zur Oberfläche orientiert sind. Letztere können jedoch gegenüber den ersten vernachlässigt werden, da ihre Wirkung infolge des geringen Neigungswinkels des Streifens gegenüber dem B₀-Feld um Größenordnungen kleiner ist. Es darf deshalb in Zukunft angenommen werden, dass der Leiterstreifen exakt parallel zum B₀-Feld orientiert ist und nur magnetische Dipole enthält, die parallel zur Oberfläche des Streifens orientiert sind.

Es sind hauptsächlich fünf Erkenntnisse, die zur vorliegenden Erfindung geführt haben und in der Folge benützt werden:
**1. Es müssen nur die Störkomponenten parallel zum statischen Feld B₀ berücksichtigt werden.**
   Es ist bekannt, dass in der NMR-Spektroskopie die Resonanzfrequenz vom Absolutbetrag des magnetischen Feldes am Ort der Messprobe abhängig ist. Dieser Absolutbetrag setzt sich aus der vektoriellen Summe des starken statischen Magnetfeldes B₀ und der drei viel schwächeren Störkomponenten ΔB_{X}, ΔB_{Y} und ΔB_{Z} zusammen. Da die beiden Störkomponenten ΔB_{X} und ΔB_{Y} senkrecht zum B₀-Feld stehen, besitzen sie einen verschwindend kleinen Einfluss auf den Absolutbetrag im Vergleich zur Komponente ΔB_{Z}, die parallel zu B₀ orientiert ist. Aus diesem Grunde genügt es bei NMR-**Betrachtungen, nur die B_{Z}-Komponente des Störfeldes zu berücksichtigen.**
**2. Leiterstreifen parallel zum statischen Magnetfeld B₀ erzeugen nur an ihren beiden Enden B_{z}-Komponenten.**
   Ein dünner Leiterstreifen mit der Suszeptibilität χ_{L}, bei dem die Längsachse parallel zum B₀-Feld orientiert ist (Fig. 3), besitzt in seinem Innern magnetische Dipole, die alle parallel zum B₀-Feld und damit auch parallel zur Fläche des Streifens orientiert sind. Dadurch entstehen an seinen beiden Enden magnetische Monopole, die ein inhomogenes Feld und damit auch inhomogene B_{Z}-Komponenten im Bereich dieser beiden Enden erzeugen. Wenn diese beiden Enden jedoch weit voneinander entfernt sind, d.h. wenn der kleinste Abstand des aktiven Messvolumens zu den beiden Enden des Streifens groß gegenüber dem Abstand s zwischen dem Zentrum des aktiven Messvolumens und dem Streifen ist, dann entstehen im Bereich des aktiven Messvolumens praktisch keine Feldinhomogenitäten und damit auch praktisch keine Beeinflussung des NMR-Spektrums.
**3. Leiterstreifen, die entweder senkrecht oder schräg zum statischen Magnetfeld B₀ orientiert sind, sich aber in Richtung des B₀-Feldes über eine längere Strecke periodisch kontinuierlich wiederholen, bilden eine in z-Richtung makroskopisch homogene Struktur, die nur an ihren beiden in z-Richtung vorhandenen Enden größere B_{z}-Komponenten erzeugen.**
   Ein Leiterstreifen mit der Suszeptibilität χ_{L}, der Länge c und der Breite d, wobei d klein gegenüber dem kleinsten Abstand zwischen dem aktiven Messvolumen und dem Streifen ist, und bei dem die Längsachse senkrecht und die Querachse parallel zum B₀-Feld orientiert ist, besitzt in seinem Innern magnetische Dipole, die alle parallel zum B₀-Feld und damit auch parallel zur Fläche des Streifens orientiert sind. Dadurch entstehen an seinen beiden Längskanten magnetische Monopole, die ein inhomogenes Feld und damit auch inhomogene B_{Z}-Komponenten im Bereich dieser beiden Längskanten erzeugen. Da die beiden Längskanten nahe beieinander liegen, treten auch im Bereich des aktiven Messvolumens stark inhomogene B_{Z}-Komponenten auf (= (ΔB_{Z})₁ in Fig. 4).
   Wenn nun eine Vielzahl solcher Streifen gleichmäßig und eng aneinander folgend in z-Richtung angeordnet werden (Fig. 5), entsteht dadurch eine in z-Richtung periodisch kontinuierliche Streifenstruktur, welche in ihrem mittleren Bereich, d.h. im Bereich des aktiven Messvolumens, praktisch keine B_{Z}-Komponenten erzeugt. Der Grund dafür liegt darin, dass nur die äußersten Längskanten der beiden an den Enden der Streifenstruktur befindlichen Leiterstreifen Monopole besitzen, die nicht kompensiert sind. Alle übrigen Längskanten innerhalb der Streifenstruktur besitzen zwar auch Monopole, doch kompensieren sich diese gegenseitig, sofern bestimmte Bedingungen erfüllt werden.
   Fig. 5 zeigt als Beispiel eine Streifenstruktur mit 11 Streifen, die auf einer Ebene parallel zur z-Achse und in gleichen Abständen übereinander angeordnet sind. Das resultierende B_{Z}-Feld ist durch die Kurve (ΔB_{Z})ₜₒₜ gegeben. Solange der Abstand h der Streifen klein gegenüber dem Abstand s zwischen der Streifenstruktur und dem Zentrum des aktiven Messvolumens ist (in Fig. 5 wurde diese Bedingung aus darstellungstechnischen Gründen nicht eingehalten), und solange die Länge k der Streifenstruktur in z-Richtung groß gegenüber dem Abstand s ist, kompensieren sich die von den einzelnen Streifen erzeugten B_{Z}-Inhomogenitäten im Bereich des aktiven Messvolumens gegenseitig praktisch zu Null. Dadurch entsteht dort ein sehr homogener Bereich mit praktisch nur einem kleinen quadratischen Gradienten, der problemlos mit dem Shimsystem kompensiert werden kann. Größere B_{z}-Inhomogenitäten treten nur noch am oberen und unteren Ende der Streifenstruktur auf.
   Wenn jedoch der Abstand h der Steifen nicht mehr klein gegenüber dem Abstand s zwischen dem Zentrum des aktiven Messvolumens und der Streifenstruktur gewählt wird, dann kann die Periodizität der Streifenstruktur wellenförmige B_{Z}-Komponenten im Bereich des aktiven Messvolumens erzeugen, die nicht mehr mit dem Shimsystem sauber kompensiert werden könnten und dadurch das NMR-Spektrum zu stark verzerren würden.
   Diese Erkenntnis gilt nicht nur für Streifen, die senkrecht zur z-Achse orientiert sind (Fig. 5), sondern auch für solche, die schräg zur z-Achse stehen, oder auch für beliebige andere, in z-Richtung periodische Strukturen.
**4. Wenn Leiterteile innerhalb von kleinen Flächenelementen gedreht oder verschoben werden, ändert sich das von ihnen erzeugte Magnetfeld am Ort des aktiven Messbereichs praktisch nicht.**
   Eine beliebige Leiterstruktur mit der Suszeptibilität χ_{L}, die auf einer Trägerfläche aufgebaut ist, kann in ein Netz von kleinen, gleichen quadratischen Flächenelementen eingeteilt werden, deren Seitenlänge klein gegenüber dem Abstand zum Zentrum des aktiven Messbereiches ist.
   Der Leiter im einzelnen Flächenelement besitzt unzählige mikroskopisch kleine magnetische Dipole, die parallel zum B₀-Feld orientiert sind. Da diese Dipole in einem Flächenbereich liegen, der klein gegenüber dem Abstand zum Zentrum des aktiven Messbereiches ist, dürfen sie zu einem einzigen Ersatzdipol im Zentrum des Flächenelementes zusammengefasst werden. Die Wirkung auf das Feld am Ort des aktiven Messbereichs bleibt dadurch unverändert.
   Der Leiter darf somit innerhalb seines Flächenelementes gedreht, verschoben und sogar in seiner geometrischen Form verändert werden, ohne dass dadurch das Feld im aktiven Messbereich geändert wird - einzige Bedingung ist, dass die Masse des Leiters und damit die Anzahl der mikroskopisch kleinen Dipole innerhalb des Flächenelementes gleich groß geblieben ist.
**5. Der Einfluss von einzelnen, schmalen Unterbrechungen in den Leiterstreifen kann vernachlässigt werden.**
   Einzelne Unterbrechungen in den Leiterstreifen haben keinen merklichen Einfluss auf die B_{Z}-Homogenität im aktiven Messbereich. Eine Unterbrechung kann nämlich als Überlagerung eines Volumenbereichs mit entgegengesetzt polarisierten Dipolen betrachtet werden. Da das Volumen der Unterbrechung im Allgemeinen sehr klein ist, wird auch sein Ersatzdipol sehr klein sein, so dass dessen Einfluss auf das Feld im aktiven Messvolumen vernachlässigt werden darf.

Aus den oben aufgezählten Erkenntnissen geht hervor, dass Leiterstrukturen, deren Breite konstant und Länge groß gegenüber dem aktiven Messbereich ist, die eine parallel zum B₀-Feld orientierte Längsachse und eine in z-Richtung makroskopisch homogene Verteilung der Leiterteile besitzen, nur B_{z}-Komponenten am oberen und unteren Ende der Leiterstrukturen erzeugen, aber praktisch keine im zentralen Bereich, wo sich die Messprobe befindet. Die Länge dieser Leiterstrukturen muss jedoch so groß sein, dass die an den Enden erzeugten Felder ein vernachlässigbar kleines Störfeld im aktiven Messbereich erzeugen.

Eine in z-Richtung makroskopisch homogene Verteilung der Leiterteile kann dadurch erreicht werden, dass die Fläche der gesamten Leiterstruktur in ein Raster von gleichen quadratischen Flächenelementen eingeteilt wird, deren Seitenlänge klein gegenüber dem kleinsten Abstand zum aktiven Messvolumen ist, und der Leiter derart auf die einzelnen Flächenelemente verteilt wird, dass in allen Flächenelementen, die sich nur in ihrer z-Position unterscheiden, eine weitgehend gleiche Masse von normal leitendem Material enthalten ist. Dadurch können Leiterstrukturen entstehen, die z.B. aus verschiedenen geometrischen Formen zusammengesetzt sind, z.B. aus Streifen verschiedener Orientierung und Breite sowie aus Rechtecken, Kreisen, Trapezen, etc, ohne dass diese Leiterstrukturen Störfelder im aktiven Messbereich erzeugen. Beispiele für solche Leiterstrukturen sind in Fig. 2a und 2b dargestellt.

Die obigen Leiterstrukturen können auch aus identischen, schmalen Leiterabschnitten bestehen, die eng aufeinander folgend und periodisch kontinuierlich in z-Richtung angeordnet sind. Dabei müssen die Leiterabschnitte so eng aufeinander folgen, dass die Welligkeit des von ihnen erzeugten Störfeldes im aktiven Messbereich vernachlässigbar klein ist.

Wenn die Leiterabschnitte innerhalb der Leiterstruktur geradlinig verlaufen, parallel zum B₀-Feld orientiert sind und zudem über die ganze Länge in z-Richtung der Leiterstruktur verlaufen, dann müssen diese nicht mehr periodisch kontinuierlich sondern dürfen mit beliebigen Abständen zueinander quer zur z-Richtung angeordnet werden. Der Grund dafür liegt darin, dass jeder einzelne Leiterabschnitt für sich keine Inhomogenitäten im Bereich des aktiven Messvolumens erzeugt.

Solche Leiterstrukturen, wie sie oben beschrieben wurden, wollen wir in Zukunft "**Z-Strukturen**" nennen. Die vorliegende Erfindung geht von mehreren solcher Z-Strukturen aus, die eng nebeneinander und/oder aufeinander angeordnet werden, und baut aus einem bestimmten Bereich dieser Leiterstrukturen den gewünschten HF-Resonator. Der verbleibende Teil dieser Leiterstrukturen trägt nur noch zur Kompensation der Suszeptibilität des HF-Resonators bei und sollte im Idealfall keinen HF-Strom tragen. HF-Strom sollte nur im HF-Resonator fließen, und deshalb muss dieser möglichst gut HF-mäßig von den übrigen Leitern entkoppelt sein.

Um den HF-Resonator aus den Z-Strukturen aufzubauen werden einzelne ausgesuchte Leiteranteile innerhalb ihrer Flächenelemente gedreht oder verschoben gemäß **Erkenntnis 4**, sowie einzelne Leiterabschnitte miteinander verbunden oder unterbrochen.

Der restliche Teil der Z-Struktur, der nicht zum HF-Resonator gehört, lässt sich ebenfalls gemäß **Erkenntnis 4** modifizieren, wobei z.B. vertikale Leiteranordnungen in horizontale umgewandelt werden können, um dadurch eine Verringerung der HF-Kopplung mit dem HF-Resonator zu erreichen.

Zwei wichtige Punkte, die sich auf Z-Strukturen beziehen, sollten an dieser Stelle noch erwähnt werden:
1. Die Z-Strukturen müssen nicht auf einer Ebene liegen, sie können auf allen in z invarianten Flächen realisiert werden, insbesondere auch auf Zylinderflächen.
2. Die Z-Strukturen müssen zwar eine über z konstante Breite aufweisen, die Abschlüsse an den beiden Enden in z-Richtung dürfen jedoch beliebig geformt sein, z.B. schräg oder gekrümmt. Da diese Abschlüsse weit weg vom aktiven Messbereich liegen, haben sie so oder so keinen Einfluss auf die Feldhomogenität im Messbereich.

Die beschriebenen Ideen lassen viele Realisierungsmöglichkeiten zu, von denen wir nur einige beschreiben wollen. Alle nun folgenden Ausführungsformen gehen von nur drei Z-Strukturen aus, zwei mit parallel zum B₀-Feld und eine senkrecht zum B₀-Feld orientierten Leiterabschnitten, die auf einer z-invarianten Fläche im radialen (x,y) Abstand von der Messprobe angeordnet sind. Diese Flächen können insbesondere eben oder zylinderförmig sein.

### Erste Ausführungsform:

In der ersten Ausführungsform der erfinderischen Idee besteht die erste Z-Struktur aus Streifen parallel zum B₀-Feld, eng gefolgt von einer zweiten mit Streifen senkrecht zum B₀-Feld, und diese wiederum eng gefolgt von einer dritten mit Streifen parallel zum B₀-Feld. Ein Beispiel dazu ist in Fig. 7a dargestellt, wobei die drei Z-Strukturen auf einer Ebene angeordnet und so gewählt sind, dass daraus ein HF-Resonator vom Typ Fig. 10a aus der Offenlegungsschrift [1] hergestellt werden kann. Der Bereich der Z-Strukturen, aus denen der HF-Resonator entstehen soll, ist in Fig. 7a schraffiert dargestellt (Bereich 7a). Aus der linken Z-Struktur 8a, die am nächsten zur Messprobe liegt, werden die vorwiegend felderzeugenden Leiter hergestellt, aus der mittleren 9a die oberen und unteren Querleiter, und aus der rechten 10a die kapazitiven Anteile. Die rechte Leiterstruktur 10a besitzt doppelt so viele Leiter wie die linke Leiterstruktur 8a, damit die kapazitiven Anteile erzeugt werden können.

Die Problematik liegt in der Erzeugung der Ecken des HF-Resonators, die aus den schraffierten Teilen der Leiterstrukturen 8a und 10a (Fig. 7a) entstehen müssen. Gelöst wird dieses Problem dadurch, dass bestimmte schraffierte Leiteranteile innerhalb ihren zugehörigen Flächenelementen gedreht oder verschoben werden, was gemäß **Erkenntnis 4** ja erlaubt ist.

Fig. 8a zeigt, wie dieses Problem gelöst wird. Ausgehend von drei Leitern mit den Flächenelementen (A1+A2+A3), (B1+B2+B3) resp. (C1+C2+C3), werden innerhalb den Flächenelementen A2, B2 und C2 die Leiteranteile S1, S3, S4, S5 und S6 so gedreht und verschoben, dass eine erste Ecke des HF-Resonators entsteht. Eine zweite Ecke entsteht auf analoge Weise innerhalb der Flächenelemente B3 und C3. Das Resultat dieser Transformation ist in Fig. 8b dargestellt.

Nach Erzeugung aller Ecken gemäß den oben beschriebenen Anweisungen, erhält man die gesamte Struktur des HF-Resonators, wie sie in Fig. 9a als schraffierte Fläche dargestellt ist. Diese ist magnetisch praktisch identisch zu der schraffierten Fläche von Fig. 7a und erzeugt deshalb keine störenden B_{z}-Komponenten im aktiven Messbereich.

Die Leiterstruktur von Fig. 9a besitzt den Nachteil, dass die HF-Feldlinien des HF-Resonators die Kompensationsstruktur aus dicht aneinander liegenden horizontalen Streifen durchstoßen müssen und dabei stark behindert werden, weil nur geringe Zwischenräume vorhanden sind, durch welche die Feldlinien ihren Weg finden können. Insbesondere die horizontalen Streifen im Bereich 7a, die vom HF-Resonator umschlossen werden, müssen die größte Konzentration an Feldlinien durchlassen und bilden deshalb das größte Hindernis.

### Zweite Ausführungsform:

Um den Nachteil der ersten Ausführungsform möglichst zu vermeiden, wurde in einer zweiten Ausführungsform der erfinderischen Idee die mittlere Leiterstruktur 9a von Fig. 7a durch die "durchsichtigere" Leiterstruktur 9b von Fig. 7b ersetzt. Nach Ausführung der bereits oben beschriebenen Transformation erhält man die Struktur von Fig. 9b, die wesentlich "durchsichtiger" für die HF-Feldlinien ist und deshalb bessere HF-Eigenschaften besitzt.

### Dritte Ausführungsform:

.Mehr Variationsmöglichkeiten erhält man, wenn die Z-Strukturen einer HF-Empfangsspulenanordnung nicht auf einer einzigen, sondern auf zwei eng nebeneinander liegenden und sich deckenden Flächen verteilt werden. Mit Hilfe der zusätzlichen Fläche können Leiterstrukturen gebaut werden, die mit nur einer Fläche zu Kreuzungen und Überlappungen der Leiter führen würden. Wenn der Abstand der beiden sich deckenden Flächen klein gegenüber dem Abstand dieser Flächen zum Zentrum des aktiven Messvolumens ist, dann können alle Überlegungen betreffend der Kompensation der Suszeptibilität der Leiter unter der Annahme gemacht werden, dass die beiden Flächen zu einer einzigen gemeinsamen Fläche zusammengeschmolzen sind.

Die beiden Flächen können z.B. durch eine dünne, elektrisch isolierende Folie voneinander getrennt sein, oder eines der elektrisch isolierenden Trägerelemente, auf dem eine der beiden Flächen zu liegen kommt, könnte die Funktion der isolierenden Folie übernehmen.

Man beachte zudem, dass die beiden Flächen als Teile einer gemeinsamen z-invarianten Fläche betrachtet werden können!

Als Beispiel für die dritte Ausführungsform soll ein NMR-Resonator vom Typ Fig. 10a aus dem Patent [1] gebaut werden. Man geht wiederum von drei Z-Strukturen aus, nämlich zwei, deren Leiterelemente parallel zum B₀-Feld orientiert sind (Fig. 10a), und eine dritte mit Leiterelementen senkrecht zum B₀-Feld (Fig. 10b). Die beiden Leiterstrukturen in Fig. 10a und Fig. 10b sind zwar getrennt dargestellt, tatsächlich liegen sie jedoch genau aufeinander, so dass Kreuzungen und Überlappungen der Leiterelemente vorhanden sind.

Die Aufgabe liegt nun darin, die oben beschriebenen Leiterelemente derart auf zwei Flächen zu verteilen, dass alle Kreuzungen oder Überlappungen verschwinden und ein funktionsfähiger HF-Resonator entsteht.

Aus der ersten Z-Struktur links in Fig. 10a, die am nächsten zur Messprobe positioniert wird, werden die vorwiegend felderzeugenden Anteile des HF-Resonators abgeleitet, aus der zweiten rechts in Fig. 10a die kapazitiven Anteile, wobei die zweite Z-Struktur doppelt so viele Leiter wie die erste besitzt, damit der kapazitive Anteil des HF Resonators realisiert werden kann.

Aus der dritten Z-Struktur (Fig. 10b) werden die Querverbindungen des HF-Resonators abgeleitet. Die Breite L_{B} dieser Z-Struktur ist gleich der Breite L_{A} der beiden Z-Strukturen von Fig. 10a, d.h. die drei Z-Strukturen überdecken sich genau.

Wie nun diese drei Z-Strukturen auf die beiden Flächen verteilt werden, ist in Fig. 11a und 11b dargestellt. Die erste Fläche (Fig. 11a) enthält den gesamten HF-Resonator sowie den Hauptanteil der Leiterstrukturen, mit denen die Suszeptibilität der Leiter kompensiert wird. Die zweite Fläche (Fig. 11b) enthält die übrigen Leiterstrukturen, mit denen der Restanteil der Suszeptibilität kompensiert wird. Man beachte, dass die Leiterstrukturen auf den beiden Flächen keine Kreuzungen oder Überlappungen mehr besitzen. Ferner sind die beiden zusammengenommenen Leiterstrukturen von Fig. 11a und Fig. 11b praktisch identisch zu den beiden zusammengenommenen Leiterstrukturen von Fig. 10a und 10b, bis auf einen vernachlässigbaren Fehler infolge des endlichen Abstandes zwischen den beiden Flächen. Da wir von den ursprünglichen Leiterstrukturen (Fig.10a und 10b) wissen, dass sie keine B_{z}-Komponenten im aktiven Messvolumen erzeugen, gilt dies natürlich jetzt auch für die neuen Leiterstrukturen (Fig. 11a und 11b) auf den beiden Flächen.

Der Vorteil dieser dritten Ausführungsform liegt in den größeren Möglichkeiten, neue Leiterstrukturen für die HF-Empfangsspulenanordnungen zu entwerfen. Der Nachteil ist, dass zwei einzelne Trägerelemente oder ein beidseitig beschichtetes Trägerelement erforderlich sind resp. ist, deren Strukturen exakt aufeinander positioniert sein müssen.

### Verbesserungsmöglichkeiten an bekannten Resonatoren:

Alle weiter oben beschriebenen Erkenntnisse können auch dazu benutzt werden, bekannte Resonatoren in ihrem Störverhalten zu verbessern. Fig. 2e zeigt einen solchen bekannten NMR-Resonator, der aus einzelnen Fingern besteht, die ineinander greifen, kapazitiv miteinander koppeln und gesamthaft einen sogenannten Birdcage-Resonator darstellen. Man erkennt leicht, dass der obere und untere Bereich des Resonators mehr Masse pro Flächenelement besitzt als der Bereich mit den ineinander greifenden Fingern. Um eine Verbesserung zu erreichen, können zwei Maßnahmen getroffen werden:
1. Die Abmessung des Resonators in z-Richtung wird vergrößert, damit die obere und untere Kante des Resonators weiter weg vom aktiven Messvolumen rückt. An diesen beiden Kanten entstehen nämlich magnetische Monopole, die nicht kompensiert werden können, und damit ihr Störeinfluss möglichst klein ist, muss ihr Abstand zum aktiven Messvolumen möglichst groß sein.
2. Um die zu hohe Massenkonzentration im oberen und unteren Bereich des Resonators zu reduzieren, werden in diesen Bereichen Löcher ausgeschnitten. Diese können eine beliebige Form besitzen, z.B. rechteckig oder rund, müssen aber so verteilt werden, dass im gesamten Resonator alle Flächenelemente, die sich nur in ihrer z-Position unterscheiden, eine weitgehend gleiche Leitermasse enthalten. Zudem ist zu beachten, dass der gelochte Bereich sowohl Ströme parallel wie auch senkrecht zur z-Achse erlauben muss.

Durch diese beiden Maßnahmen lässt sich der Störeinfluss, hervorgerufen durch die Suszeptibilität des Leiters, stark reduzieren. Fig. 2c zeigt einen gemäß diesen Anweisungen modifizierten Resonator, bei dem der Störeinfluss wesentlich geringer ist als beim bekannten Resonator von Fig. 2e.

Die gleichen Überlegungen gelten auch bei Resonatoren mit schrägen Fingern, die spiralförmig über einen Winkelbereich von 2π um eine Zylinderfläche gewickelt sind. Fig. 2f zeigt den unkorrigierten, Fig. 2d den korrigierten Resonator. Diese Art von Resonatoren haben den Vorteil, dass sie praktisch keine HF-Kopplung untereinander besitzen, wenn sie konzentrisch zueinander positioniert werden.

Zusammenfassend sollen alle Prozeduren aufgezählt werden, mit denen die HF-Empfangsspulenanordnung aus den gewünschten Bereichen der Z-Strukturen gebaut werden kann. Die nachfolgend aufgeführten Prozeduren können erfindungsgemäß einzeln, in Gruppen oder alle zugleich angewendet werden:
1. Drehen oder verschieben von Leiterteilen innerhalb von kleinen Flächenelementen.
2. Überbrücken von schmalen Zwischenräumen zwischen benachbarten Leitern.
3. Anbringen von schmalen Unterbrüchen in den Leitern.
4. Z-Strukturen zerlegen und auf zwei Substrate verteilen, so dass auf keinem der beiden Substrate Kreuzungen oder Überlappungen vorhanden sind.

Die Leiter der Kompensations-Anordnung können zusätzlich noch mit schmalen Unterbrüchen versehen werden, um die HF-Kopplung mit dem HF-Resonator zu minimieren. Solche Unterbrüche sind in Fig. 9c für die zweite Ausführungsform (Fig. 9b) dargestellt, sie lassen sich aber auch bei allen anderen Ausführungsformen realisieren, auch wenn sie dort nicht explizit dargestellt sind.

Aus der Literatur [2] ist eine Anordnung bekannt, mit dem der Störeinfluss auf das NMR-Spektrum infolge der Suszeptibilität des NMR-Resonators wenigstens teilweise reduziert werden kann. Diese Anordnung eliminiert die Feldstörungen jedoch nur entlang der z-Achse des aktiven Messbereichs, nicht aber innerhalb seinem gesamten Volumen. Die vorliegende Erfindung geht diesbezüglich zwei wesentliche Schritte weiter und kompensiert die Feldstörungen nicht nur auf einer Geraden und auch nicht nur auf einer Fläche, sondern innerhalb dem gesamten Volumen des aktiven Messbereichs! Dieses erstaunliche Resultat konnte aber nicht direkt aus dem Stand der Technik abgeleitet werden, sondern musste über ganz neue Wege gefunden und erarbeitet werden.

### Bezugszeichenliste zu den Figuren

### Buchstaben:

- B₀: Statisches Magnetfeld des NMR-Magneten.
- ΔB: Störfeld, das durch die Suszeptibilität des Leiters erzeugt wird.
- (ΔB_{Z})₁: z-Komponente des Störfeldes ΔB, die von einem einzelnen Leiterstreifen 2 oder 4 verursacht wird.
- (ΔB_{Z})ₜₒₜ: z-Komponente von ΔB, die von allen Leiterstreifen der Anordnung 5 verursacht wird.
- S1, S3, S4, S5, S6: Einzelne Leiteranteile, die innerhalb ihrer Flächenelemente gedreht und verschoben werden, um dadurch die Ecken des HF-Resonators herzustellen.

### Ziffern:

- 1: Aktives Messvolumen.
- 2: Langer flacher Leiter, dessen Längsachse parallel zum B₀-Feld orientiert ist.
- 3: Magnetische Dipole innerhalb des Streifens 2.
- 4: Flacher Leiter, dessen Längsachse senkrecht zum B₀-Feld orientiert ist.
- 4a, 4b, 4c, ..., 4k: Leiterstreifen wie unter 4 beschrieben, die zur Leiteranordnung 5 gehören.
- 5: Anordnung aus mehreren Leiterstreifen 4a, 4b, 4c, ... ,4k, die auf einer Ebene parallel zum B₀-Feld liegen und in z-Richtung gleichmäßig nebeneinander angeordnet sind.
- 6 7a, 7b, 7c, 7d: Bereiche der diversen HF-Empfangsspulenanordnungen, in denen sich die Leiterabschnitte befinden, die HF-Ströme tragen und zum HF-Resonator gehören.
- 8a, 8b: Z-Strukturen mit Leiterelementen, die parallel zum B₀-Feld orientiert sind, und die teilweise dazu benutzt werden, jene Leiteranteile des HF-Resonators herzustellen, die am nächsten zum aktiven Messbereich liegen und dort den Hauptanteil des HF-Feldes erzeugen.
- 9a, 9b: Z-Strukturen mit Leiterelementen, die senkrecht zum B₀-Feld orientiert sind, und die teilweise dazu benutzt werden, um die horizontalen Querverbindungen im oberen und unteren Bereich des HF-Resonators herzustellen.
- 10a, 10b: Z-Strukturen mit Leiterelementen, die parallel zum B₀-Feld orientiert sind, und die teilweise dazu benutzt werden, die kapazitiven Anteile des HF-Resonators herzustellen.

### Referenzen

[1] DE 101 18 835 A1, nachveröffentlicht
[2] DE 34 14 559 A1

## Patentansprüche

1. HF(=Hochfrequenz)-Empfangsspulenanordnung für einen NMR(= Kernspinresonanz)-Resonator mit mindestens einem HF-Resonator zum Aussenden und/oder Empfangen von HF-Signalen auf einer oder mehreren gewünschten Resonanzfrequenzen in eine und/oder aus einer Messprobe in einem um einen Koordinatenursprung (x,y,z = 0) angeordneten Untersuchungsvolumen einer NMR-Apparatur mit einer Einrichtung zur Erzeugung eines homogenen Magnetfelds B₀ in Richtung einer z-Achse, wobei zwischen z = -|z₁| und z = +|z₂| normalleitende, induktiv und zum Teil auch kapazitiv wirkende Leiterstrukturen des HF-Resonators im wesentlichen auf einer in z-Richtung translations-invarianten (= z-invarianten) Fläche im radialen (x,y) Abstand senkrecht zur z-Achse angeordnet sind,
**dadurch gekennzeichnet,**
**dass** auf der z-invarianten Fläche zusätzlich eine Kompensations-Anordnung zur Verringerung des Einflusses der Suszeptibilität des Materials des HF-Resonators auf das NMR-Spektrum vorgesehen ist, die sich zumindest in den Bereichen z < -|z₁| -0.5 |r| und z > +|z₂| + 0.5 |r| erstreckt, wobei |r| der kleinste vorkommende Abstand zwischen dem Untersuchungsvolumen und der Kompensations-Anordnung bedeutet, dass die Kompensations-Anordnung weitere normalleitende Leiterstrukturen zur Kompensation des Einflusses der Suszeptibilität des Materials des HF-Resonators auf das NMR-Spektrum umfasst, welche voneinander beabstandet und HF-mäßig vom HF-Resonator weitgehend entkoppelt sind, dass die Leiterstrukturen des HF-Resonatörs und die weiteren Leiterstrukturen der Kompensations-Anordnung ihrerseits aus einzelnen, normalleitende Strukturen enthaltenden Flächenabschnitten (="Z-Strukturen") zusammengesetzt sind, die in der z-invarianten Fläche liegen, jeweils über die ganze Länge in z-Richtung der Leiterstrukturen der Kompensations-Anordnung und des HF-Resonators verlaufen, und deren Strukturen so angeordnet sind, dass bei einer geeigneten mathematischen Zerlegung der Fläche der Z-Strukturen in eine Vielzahl kleiner, gleich großer Flächenelemente, in allen Flächenelementen, die sich nur in ihrer z-Position unterscheiden, eine weitgehend gleiche Masse von normalleitendem Material enthalten ist.

2. HF-Empfangsspulenanordnung nach Anspruch 1, **dadurch gekennzeichnet, dass** die Gesamtzahl der Flächenelemente größer ist als 50, vorzugsweise größer als 200.

3. HF-Empfangsspulenanordnung nach einem der vorhergehenden Ansprüche, **dadurch gekennzeichnet, dass** die Anzahl der Flächenelemente, die sich nur durch ihre z-Position unterscheiden, größer ist als 20, vorzugsweise größer als 50.

4. HF-Empfangsspulenanordnung nach einem der vorhergehenden Ansprüche, **dadurch gekennzeichnet, dass** die Leiterstrukturen der Kompensations-Anordnung den HF-Resonator beidseits jeweils um mindestens die halbe, vorzugsweise etwa die zweifache Ausdehnung des HF-Resonators in z-Richtung überragen.

5. HF-Empfangsspulenanordnung nach einem der vorhergehenden Ansprüche, **dadurch gekennzeichnet, dass** die induktiv und zum Teil auch kapazitiv wirkenden Leiterstrukturen des oder der HF-Resonatoren sowie die Leiterstrukturen der Kompensations-Anordnung(en) auf ebenen Substratelementen aufgebracht sind, die untereinander und zur z-Achse parallel angeordnet sind.

6. HF-Empfangsspulenanordnung nach einem der vorhergehenden Ansprüche, **dadurch gekennzeichnet, dass** die induktiv und zum Teil auch kapazitiv wirkenden Leiterstrukturen des oder der HF-Resonatoren sowie die Leiterstrukturen der Kompensations-Anordnung(en) auf zylinderförmigen Substratelementen aufgebracht sind, die untereinander konzentrisch und zur z-Achse parallel angeordnet sind.

7. HF-Empfangsspulenanordnung nach einem der vorhergehenden Ansprüche, **dadurch gekennzeichnet, dass** die induktiv und zum Teil auch kapazitiv wirkenden Leiterstrukturen des HF-Resonators sowie die Leiterstrukturen der zugehörigen Kompensations-Anordnung in derselben Ebene oder auf derselben Zylinderfläche angeordnet sind.

8. HF-Empfangsspulenanordnung nach einem der vorhergehenden Ansprüche, **dadurch gekennzeichnet, dass** die Leiterstrukturen der Kompensations-Anordnung und des HF-Resonators auf derselben Teilfläche der z-invarianten Fläche angeordnet sind.

9. HF-Empfangsspulenanordnung nach einem der Ansprüche 1 bis 7, **dadurch gekennzeichnet, dass** die Strukturen des HF-Resonators und der zugehörigen Kompensationsanordnung in zwei oder mehreren ebenen oder zylinderförmigen Teilflächen der z-invarianten Fläche liegen, die parallel resp. konzentrisch zueinander angeordnet sind, wobei in der ersten Teilfläche die induktiv und zum Teil auch kapazitiv wirkenden Leiterstrukturen des HF-Resonators sowie Teile der zugehörigen Leiterstrukturen der Kompensations-Anordnung, in den weiteren Teilflächen die verbleibenden Teile der Leiterstrukturen der Kompensations-Anordnung angeordnet sind.

10. HF-Empfangsspulenanordnung nach Anspruch 9, **dadurch gekennzeichnet, dass** die Abstände zwischen den Teilflächen, gemessen in einer Richtung senkrecht zu den Teilflächen, maximal 600µm, vorzugsweise maximal zwischen 50 und 200µm betragen.

11. HF-Empfangsspulenanordnung nach einem der vorhergehenden Ansprüche, **dadurch gekennzeichnet, dass** zumindest ein Teil der Abschnitte der Leiterstrukturen streifenförmig achsparallel oder achssenkrecht zur z-Richtung angeordnet ist.

12. HF-Empfangsspulenanordnung nach einem der vorhergehenden Ansprüche, **dadurch gekennzeichnet, dass** die Strukturen auf den z-invarianten Flächen aus verschiedenen geometrischen Formen zusammengesetzt sind, z.B. aus Streifen verschiedener Orientierung und Breite sowie aus Rechtecken, Kreisen, Trapezen, etc.

13. HF-Empfangsspulenanordnung nach einem der vorhergehenden Ansprüche, **dadurch gekennzeichnet, dass** eine oder mehrere seiner Z-Strukturen aus identischen, schmalen Leitern aufgebaut ist, die eng aufeinander folgend und periodisch kontinuierlich in z-Richtung angeordnet sind, wobei der Abstand benachbarter Leiter klein gegenüber dem kleinsten Abstand zum Untersuchungsvolumen ist.

14. HF-Empfangsspulenanordnung nach einem der vorhergehenden Ansprüche, **dadurch gekennzeichnet, dass** eine oder mehrere seiner Z-Strukturen aus Leitern bestehen, die parallel zur z-Achse ausgerichtet sind und gleiche oder unterschiedliche Abstände zueinander haben.

15. HF-Empfangsspulenanordnung nach einem der vorhergehenden Ansprüche, **dadurch gekennzeichnet, dass** die Leiterstrukturen, die nicht zum HF-Resonator gehören, eine Anzahl von schmalen Unterbrüchen enthalten, die über Teile oder die ganze Länge der einzelnen Leiterabschnitte verteilt sind.

16. HF-Empfangsspulenanordnung nach einem der Ansprüche 1 bis 11, **dadurch gekennzeichnet, dass** die Erzeugung des HF-Resonators aus den gewünschten Bereichen der Z-Strukturen dadurch erreicht wird, dass innerhalb von kleinen Flächenelementen der Z-Strukturen der darin enthaltene Leiter oder Teile davon gedreht oder verschoben werden, und/oder dass schmale Abstände zwischen den Leitern galvanisch verbunden werden, und/oder dass schmale Unterbrüche in den Leitern angebracht werden, und/oder dass schräge Z-Strukturen verwendet werden, und/oder dass die Z-Strukturen auf zwei oder mehreren Teilflächen verteilt werden.

17. HF-Empfangsspulenanordnung nach einem der Ansprüche 1 bis 14 oder 16, **dadurch gekennzeichnet, dass** diese aus drei Z-Strukturen aufgebaut ist, nämlich aus zwei z-Strukturen mit vertikalen geraden Streifen und einer z-Struktur mit horizontalen geraden Streifen, wobei die z-Struktur mit horizontalen streifen zwischen den z-Strukturen mit vertikalen Streifen angeordnet ist.

18. HF-Empfangsspulenanordnung nach einem der Ansprüche 1 bis 16, **dadurch gekennzeichnet, dass** diese aus drei Z-Strukturen zusammengesetzt ist, nämlich aus einer ersten und zweiten mit parallel zur z-Achse sowie einer dritten mit in z periodisch und quer zur z-Achse angeordneten Streifen, wobei die dritte Z-Struktur über den beiden ersten, die einen bestimmten Abstand zueinander haben, positioniert ist und diese genau überdeckt, und wobei die Zusammensetzung des HF-Resonators und der Kompensationsstruktur dadurch erfolgt, dass die drei Z-Strukturen teilweise zerlegt und auf zwei separaten Teilflächen, die zu einem oder zwei Substraten gehören, verteilt werden, wobei die erste Teilfläche den ganzen HF-Resonator mit dem Hauptanteil der Kompensations-Struktur, und die zweite Teilfläche den Restanteil der Kompensations-Struktur enthält, und dass die so entstandenen Strukturen auf den beiden Teilflächen derart aufeinander positioniert werden, dass die Summe ihrer Strukturen wieder gleich der Summe der drei Z-Strukturen vor der Zerlegung ist, und dass dadurch ein funktionsfähiger NMR-Resonator entsteht.

19. NMR-Resonator, der eine oder mehrere HF-Empfangsspulenanordnungen nach einem der vorhergehenden Ansprüche umfasst.

20. NMR-Resonator nach Anspruch 19, der aus mehreren, vorzugsweise 2 oder 4 HF-Empfangsspulenanordnungen nach einem der Ansprüche 1 bis 18 aufgebaut ist, wobei diese HF-Empfangsspulenanordnungen miteinander HF-mäßig koppeln und auf unterschiedlichen Teilflächen der z-invarianten Fläche liegen.

## Claims

1. RF (radio frequency) receiver coil arrangement for an NMR (nuclear magnetic resonance) resonator with at least one RF resonator for emitting and/or receiving RF signals at one or more desired resonance frequencies to and/or from a measuring sample in an investigational volume of an NMR apparatus, disposed about a coordinate origin (x,y,z = 0), with a means for generating a homogeneous magnetic field B₀ in the direction of a z-axis, wherein normally conducting conductor structures of the RF resonator, which act inductively and partially also capacitively, are disposed between z = -|z₁| and z = +|z₂| substantially on a surface which is translation-invariant (=z-invariant) in the z-direction at a radial (x,y) separation perpendicular to the z-axis,
**characterized in that**
a compensation arrangement is additionally provided on the z-invariant surface for reducing the influence of the susceptibility of the RF resonator material on the NMR spectrum, which extends at least in the regions z < - |z₁| -0.5 |r| and z > +|z₂| +0.5|r|, wherein |r| is the minimum separation between the investigational volume and the compensation arrangement, wherein the compensation arrangement comprises further normally conducting conductor structures for compensating the influence of the susceptibility of the RF resonator material on the NMR spectrum, which are disposed at a separation from each other and are largely RF-decoupled from the RF resonator, the conductor structures of the RF resonator and the further conductor structures of the compensation arrangement being composed of individual surface sections ("Z-structures") which comprise normally conducting structures, are disposed in the z-invariant surface and each extend over the entire length in the z-direction of the conductor structures of the compensation arrangement and of the RF resonator, and whose structures are disposed such that, with suitable conceptual decomposition of the surface of the Z-structures into a plurality of small, equally sized surface elements, all surface elements which differ only with respect to their z-position contain a largely identical mass of normally conducting material.

2. RF receiver coil arrangement according to claim 1, **characterized in that** the total number of the surface elements is larger than 50, preferably larger than 200.

3. RF receiver coil arrangement according to any one of the preceding claims, **characterized in that** the number of the surface elements which differ from each other only with respect to their z-position is larger than 20, preferably larger than 50.

4. RF receiver coil arrangement according to any one of the preceding claims, **characterized in that** the conductor structures of the compensation arrangement project past both sides of the RF resonator by at least half, preferably approximately twice the extension of the RF resonator in the z-direction.

5. RF receiver coil arrangement according to any one of the preceding claims, **characterized in that** the conductor structures of the RF resonator(s), which act inductively and partially also capacitively, and the conductor structures of the compensation arrangement(s) are disposed on flat substrate elements which are disposed parallel to each other and parallel to the z-axis.

6. RF receiver coil arrangement according to any one of the preceding claims, **characterized in that** the conductor structures of the RF resonator(s), which act inductively and partially also capacitively, and the conductor structures of the compensation arrangement(s) are disposed on cylindrical substrate elements which are concentric to each other and parallel to the z-axis.

7. RF receiver coil arrangement according to any one of the preceding claims, **characterized in that** the conductor structures of the RF resonator, which act inductively and partially also capacitively, and the conductor structures of the associated compensation arrangement are disposed in the same plane or on the same cylindrical surface.

8. RF receiver coil arrangement according to any one of the preceding claims, **characterized in that** the conductor structures of the compensation arrangement and of the RF resonator are disposed on the same partial surface of the z-invariant surface.

9. RF receiver coil arrangement according to any one of the claims 1 to 7, **characterized in that** the structures of the RF resonator and of the associated compensation arrangement are disposed in two or more flat or cylindrical partial surfaces of the z-invariant surface, which are parallel or concentric to each other, wherein the inductively and partially also capacitively acting conductor structures of the RF resonator and parts of the associated conductor structures of the compensation arrangement are disposed in the first partial surface and the remaining parts of the conductor structures of the compensation arrangement are disposed in the other partial surfaces.

10. RF receiver coil arrangement according to claim 9, **characterized in that** the separations between the partial surfaces, measured in a direction perpendicular to the partial surfaces, are maximally 600µm, preferably maximally between 50 and 200µm.

11. RF receiver coil arrangement according to any one of the preceding claims, **characterized in that** at least part of the sections of the conductor structures is disposed in strips parallel or perpendicular to the z-direction.

12. RF receiver coil arrangement according to any one of the preceding claims, **characterized in that** the structures on the z-invariant surfaces are composed of different geometrical shapes, e.g. of strips of different orientation and width and of squares, circles, trapezoids etc.

13. RF receiver coil arrangement according to any one of the preceding claims, **characterized in that** one or more of its Z-structures is/are built from identical, narrow conductors which are disposed in close proximity and with periodic continuity in the z-direction, wherein the separation between neighboring conductors is small compared to the smallest separation from the volume under investigation.

14. RF receiver coil arrangement according to any one of the preceding claims, **characterized in that** one or more of its Z-structures consist(s) of conductors which are oriented parallel to the z-axis and have identical or different mutual separations.

15. RF receiver coil arrangement according to any one of the preceding claims, **characterized in that** the conductor structures which do not belong to the RF resonator contain a number of narrow interruptions which are distributed over parts or over the entire length of the individual conductor sections.

16. RF receiver coil arrangement according to any one of the claims 1 through 11, **characterized in that** the RF resonator is produced from the desired regions of the Z-structures **in that** within small surface elements of the Z-structures, the conductor or parts thereof contained therein is/are turned or displaced, and/or small separations between the conductors are galvanically connected, and/or narrow interruptions are disposed in the conductors, and/or inclined Z-structures are used, and/or the Z-structures are distributed to two or more partial surfaces.

17. RF receiver coil arrangement according to any one of the claims 1 through 14 or 16, **characterized in that** it is built from three Z-structures, i.e. two z-structures with vertical straight strips and a z-structure with horizontal straight strips, wherein the z-structure with horizontal strips is disposed between the z-structures with vertical strips.

18. RF receiver coil arrangement according to any one of the claims 1 through 16, **characterized in that** it is composed of three Z-structures, i.e. a first and second structure having strips parallel to the z-axis, and a third structure having strips disposed periodically in z and transverse to the z-axis, wherein the third Z-structure is positioned over the first two, which have a defined separation from each other, and exactly covers these, the RF resonator and the compensation structure being generated by partially decomposing the three Z-structures and redistributing them to two separate partial surfaces which belong to one or two substrates, wherein the first partial surface contains the entire RF resonator with the main part of the compensation structure, and the second partial surface contains the remaining part of the compensation structure, and the structures produced in this fashion are positioned on top of each other on the two partial surfaces such that the sum of their structures is again equal to the sum of the three Z-structures prior to decomposition, thereby producing an operative NMR resonator.

19. NMR resonator comprising one or more RF receiver coil arrangements according to any one of the preceding claims.

20. NMR resonator according to claim 19, which is assembled from several, preferably two or four RF receiver coil arrangements according to any one of the claims 1 to 18, wherein these RF receiver coil arrangements are RF-coupled to each other and are disposed on different partial surfaces of the z-invariant surface.

## Revendications

1. Agencement de bobines de réception HF (= haute fréquence) pour un résonateur RMN (= résonance magnétique nucléaire) avec au moins un résonateur HF pour émettre et/ou recevoir des signaux HF sur une ou plusieurs fréquences de résonance souhaitées vers et/ou depuis un échantillon à mesurer dans un volume d'examen disposé autour d'une origine de coordonnées (x, y, z = 0) d'un appareillage RMN avec un dispositif pour générer un champ magnétique homogène B₀ en direction d'un axe z, sachant qu'entre z = -|z₁| et z = + |z₂| des structures de conducteurs normalement conductrices, ayant un effet inductif et en partie aussi capacitif, du résonateur HF sont disposées essentiellement sur une surface invariante en translation dans la direction z (= z-invariantes) à la distance radiale (x, y) perpendiculairement à l'axe z,
**caractérisé en ce**
**qu'**il est prévu en plus sur la surface z-invariante un agencement de compensation pour diminuer l'influence de la susceptibilité du matériau du résonateur HF sur le spectre RMN, qui s'étend au moins dans les plages z < -|z₁| - 0,5 |r| et z > + |z₂| + 0,5 |r|, |r| représentant la plus petite distance existante entre le volume d'examen et l'agencement de compensation, que l'agencement de compensation comprend d'autres structures de conducteurs normalement conductrices pour compenser l'influence de la susceptibilité du matériau du résonateur HF sur le spectre RMN, qui sont distantes les unes des autres et en grande partie découplées en HF du résonateur HF, que les structures de conducteurs du résonateur HF et les autres structures de conducteurs de l'agencement de compensation sont elles-mêmes composées de sections de surface (= « structures Z ») individuelles, contenant des structures normalement conductrices, qui sont situées dans la surface z-invariante, s'étendent chacune sur toute la longueur en direction z des structures de conducteurs de l'agencement de compensation et du résonateur HF, et dont les structures sont disposées de façon qu'en cas de décomposition mathématique appropriée de la surface des structures Z en une pluralité de petits éléments de surface de même dimension, tous les éléments de surface qui ne diffèrent que par leur position z contiennent une masse en grande partie égale de matériau normalement conducteur.

2. Agencement de bobines de réception HF selon la revendication 1, **caractérisé en ce que** le nombre total d'éléments de surface est supérieur à 50, de préférence supérieur à 200.

3. Agencement de bobines de réception HF selon l'une des revendications précédentes, **caractérisé en ce que** le nombre d'éléments de surface qui ne diffèrent que par leur position z est supérieur à 20, de préférence supérieur à 50.

4. Agencement de bobines de réception HF selon l'une des revendications précédentes, **caractérisé en ce que** les structures de conducteurs de l'agencement de compensation dépassent de chaque côté du résonateur HF au moins de la moitié, de préférence environ du double de l'extension du résonateur HF en direction z.

5. Agencement de bobines de réception HF selon l'une des revendications précédentes, **caractérisé en ce que** les structures de conducteurs ayant un effet inductif et en partie aussi capacitif du ou des résonateur(s) HF ainsi que les structures de conducteurs du ou des agencement(s) de compensation sont montées sur des éléments de substrat plans qui sont disposés parallèlement les uns aux autres et à l'axe z.

6. Agencement de bobines de réception HF selon l'une des revendications précédentes, **caractérisé en ce que** les structures de conducteurs ayant un effet inductif et en partie aussi capacitif du ou des résonateur(s) HF ainsi que les structures de conducteurs du ou des agencement(s) de compensation sont montées sur des éléments de substrat cylindriques qui sont disposés concentriquement les uns aux autres et parallèlement à l'axe z.

7. Agencement de bobines de réception HF selon l'une des revendications précédentes, **caractérisé en ce que** les structures de conducteurs ayant un effet inductif et en partie aussi capacitif du résonateur HF ainsi que les structures de conducteurs de l'agencement de compensation associé sont disposées dans le même plan ou sur la même surface cylindrique.

8. Agencement de bobines de réception HF selon l'une des revendications précédentes, **caractérisé en ce que** les structures de conducteurs de l'agencement de compensation et du résonateur HF sont disposées sur la même sous-surface de la surface z-invariante.

9. Agencement de bobines de réception HF selon l'une des revendications 1 à 7, **caractérisé en ce que** les structures du résonateur HF et de l'agencement de compensation associé sont situées dans deux ou plusieurs sous-surfaces planes ou cylindriques qui sont disposées parallèlement, respectivement concentriquement les uns aux autres, les structures de conducteurs ayant un effet inductif et en partie aussi capacitif du résonateur HF ainsi que des parties des structures de conducteurs associées de l'agencement de compensation étant disposées dans la première sous-surface, les parties restantes des structures de conducteurs de l'agencement de compensation dans les autres sous-surfaces.

10. Agencement de bobines de réception HF selon la revendication 9, **caractérisé en ce que** les distances entre les sous-surfaces, mesurées dans une direction perpendiculaire aux sous-surfaces, sont au maximum de 600 µm, de préférence au maximum comprises entre 50 et 200 µm.

11. Agencement de bobines de réception HF selon l'une des revendications précédentes, **caractérisé en ce qu'**au moins une partie des sections des structures de conducteurs est disposée en bande parallèlement à l'axe ou perpendiculairement à l'axe par rapport à la direction z.

12. Agencement de bobines de réception HF selon l'une des revendications précédentes, **caractérisé en ce que** les structures sur les surfaces z-invariantes sont composées de différentes formes géométriques, par exemple de bandes d'orientation et de largeur différente ainsi que de rectangles, de cercles, de trapèzes, etc.

13. Agencement de bobines de réception HF selon l'une des revendications précédentes, **caractérisé en ce qu'**une ou plusieurs de ses structures Z sont constituées de conducteurs étroits identiques qui sont disposés de manière étroitement successive et périodiquement continue en direction z, la distance entre conducteurs voisins étant petite par rapport à la plus petite distance au volume d'examen.

14. Agencement de bobines de réception HF selon l'une des revendications précédentes, **caractérisé en ce qu'**une ou plusieurs de ses structures Z sont constituées de conducteurs qui sont orientées parallèlement à l'axe z et ont entre eux des distances égales ou différentes.

15. Agencement de bobines de réception HF selon l'une des revendications précédentes, **caractérisé en ce que** les structures de conducteurs qui n'appartiennent pas au résonateur HF contiennent un certain nombre d'étroites interruptions qui sont réparties sur des parties ou sur toute la longueur des différentes sections de conducteurs.

16. Agencement de bobines de réception HF selon l'une des revendications 1 à 11, **caractérisé en ce que** la production du résonateur HF à partir des secteurs souhaités des structures Z est obtenue en tournant ou déplaçant à l'intérieur de petits éléments de surface des structures Z le conducteur qui y est contenu ou des parties de celui-ci et/ou en reliant de manière galvanique d'étroits espaces entre les conducteurs et/ou en appliquant d'étroites interruptions dans les conducteurs et/ou en utilisant des structures Z obliques et/ou en répartissant les structures Z sur deux ou plusieurs sous-surfaces.

17. Agencement de bobines de réception HF selon l'une des revendications 1 à 14 ou 16, **caractérisé en ce qu'**il est constitué de trois structures Z, à savoir de deux structures Z avec des bandes rectilignes verticales et d'une structure Z avec des bandes rectilignes horizontales, la structure Z avec des bandes horizontales étant disposée entre les structures Z avec des bandes verticales.

18. Agencement de bobines de réception HF selon l'une des revendications 1 à 16, **caractérisé en ce qu'**il est constitué de trois structures Z, à savoir d'une première et d'une deuxième avec des bandes disposées parallèlement à l'axe z ainsi que d'une troisième avec des bandes disposées périodiquement en z et transversalement à l'axe z, la troisième structure Z étant positionnée au-dessus des deux premières qui ont une certaine distance entre elles et les recouvrant exactement, et la composition du résonateur HF et de la structure de compensation étant réalisée par le fait que les trois structures Z sont partiellement décomposées et réparties sur deux sous-surfaces séparées qui appartiennent à un ou deux substrats, la première sous-surface contenant tout le résonateur HF avec la part principale de la structure de compensation et la deuxième sous-surface la part restante de la structure de compensation, et que les structures ainsi formées sont positionnées l'une sur l'autre sur les deux sous-surfaces de façon que la sommes de leurs structures soit de nouveau égale à la somme des trois structures Z d'avant la décomposition et qu'il en résulte un résonateur RMN opérationnel.

19. Résonateur RMN qui comprend un ou plusieurs agencements de bobines de réception HF selon l'une des revendications précédentes.

20. Résonateur RMN selon la revendication 19, qui est constitué de plusieurs, de préférence 2 ou 4 agencements de bobines de réception HF selon l'une des revendications 1 à 18, ces agencements de bobines de réception HF étant couplés entre eux en HF et situés sur des sous-surfaces différentes de la surface z-invariante.
